(19) Europäisches Patentamt
European Patent Office
Office européen des brevets

(11) EP 4 318 590 A1

(12) EUROPEAN PATENT APPLICATION
published in accordance with Art. 153(4) EPC

(43) Date of publication:
07.02.2024 Bulletin 2024/06

(51) International Patent Classification (IPC):
H01L 27/146 (2006.01)    H04N 5/369 (2011.01)

(21) Application number: 22779478.1

(52) Cooperative Patent Classification (CPC):
H01L 27/146; H04N 25/70

(22) Date of filing: 31.01.2022

(86) International application number:
PCT/JP2022/003572

(87) International publication number:
WO 2022/209249 (06.10.2022 Gazette 2022/40)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 31.03.2021  JP 2021060582

(71) Applicant: Sony Semiconductor Solutions
Corporation
Atsugi-shi, Kanagawa 243-0014 (JP)

(72) Inventor: SAKAMOTO, Michiko
Atsugi-shi, Kanagawa 243-0014 (JP)

(74) Representative: Müller Hoffmann & Partner
Patentanwälte mbB
St.-Martin-Strasse 58
81541 München (DE)

(54) **SOLID-STATE IMAGING DEVICE AND ELECTRONIC APPARATUS**

(57) To provide a solid-state imaging device capable of further improving the performance of the solid-state imaging device.

Provided is a solid-state imaging device including a semiconductor substrate, a photoelectric conversion unit provided on the semiconductor substrate, and a recess of two or more steps formed on a surface on a light incident side of the semiconductor substrate, and further provided is a solid-state imaging device including a semiconductor substrate, a photoelectric conversion unit provided on the semiconductor substrate, and a light-shielding wall provided above the light incident side of the semiconductor substrate, in which the light-shielding wall includes a first portion having a first width extending in a direction substantially parallel to a light incident surface of the semiconductor substrate, and a second portion having a second width extending in a direction substantially perpendicular to the light incident surface, the second width being smaller than the first width, and the second portion is provided between the first portion and the semiconductor substrate.

FIG. 1

EP 4 318 590 A1

**Description**

TECHNICAL FIELD

The present technology relates to a solid-state imaging device and an electronic device.

BACKGROUND ART

In general, solid-state imaging devices such as a complementary metal oxide semiconductor (CMOS) image sensor and a charge coupled device (CCD) are widely used in a digital still camera, a digital video camera, and the like. Under such circumstances, research and development of solid-state imaging devices for the purpose of improving the performances of the solid-state imaging devices has been actively conducted at present.

For example, a technique of suppressing color mixing deterioration while improving sensitivity by preventing reflection of incident light has been proposed (See, for example, Patent Document 1).

CITATION LIST

PATENT DOCUMENT

Patent Document 1: Japanese Patent Application Laid-Open No. 2015-029054

SUMMARY OF THE INVENTION

PROBLEMS TO BE SOLVED BY THE INVENTION

However, in the technology proposed in Patent Document 1, there is a possibility that further improvement in the performance of a solid-state imaging device that receives light having a short wavelength to a middle wavelength, particularly UV light, cannot be achieved.

Therefore, the present technology has been made in view of such a situation, and a principal object thereof is to provide a solid-state imaging device capable of further improving the performance of the solid-state imaging device, and an electronic device on which the solid-state imaging device is mounted.

SOLUTIONS TO PROBLEMS

As a result of diligent research to solve the above-described object, the present inventors have succeeded in further improving the performance of the solid-state imaging device, and have completed the present technology.

That is, a first aspect of the present technology provides a solid-state imaging device including:

a first pixel provided on a semiconductor substrate;
a photoelectric conversion unit provided in the first pixel; and
a first recess of two or more steps formed on a light incident surface of the semiconductor substrate.

In the solid-state imaging device according to the first aspect of the present technology,
a difference in height between the successive steps in the first recess may satisfy the following Expression (1).

$$\mathrm{Log}\ (2)/\alpha < x < 0.6\ \mu m\ \cdots\ (1)$$

(In Expression (1), $\alpha$ is a light absorption coefficient of the semiconductor substrate, and x is a difference in height between the successive steps.)

In the solid-state imaging device according to the first aspect of the present technology,

an on-chip lens may be provided on the light incident surface of the semiconductor substrate, and
a width of a widest portion of an entrance on a light incident side of the first recess in a cross-sectional view may satisfy the following Expression (2).

$$1.22 * \lambda/n < y < W * (f-z)/f\ \cdots\ (2)$$

(In Expression (2), $\lambda$ is a wavelength of incident light, n is an n value of the on-chip lens, W is a size (width) of the on-chip lens, f is an F value of the on-chip lens, z is a distance from an uppermost portion on a light incident side of the on-chip lens to the widest portion of the entrance on the light incident side of the first recess, and y is a width of the widest portion of the entrance on the light incident side of the first recess.)

The solid-state imaging device according to the first aspect of the present technology may further include:

a second pixel adjacent to the first pixel; and
a second recess provided in the second pixel,
in which a width of the light incident surface of the semiconductor substrate between the first recess and the second recess may satisfy the following Expression (3).

$$2 \, * \, \text{Log}(2)/\alpha \, < \, v \, < \, 1.2 \, \mu m \, \cdots \, (3)$$

(In Expression (3), $\alpha$ is a light absorption coefficient of the semiconductor substrate, and v is a width of the light incident surface of the semiconductor substrate between the first recess and the second recess.)

In the solid-state imaging device according to the first aspect of the present technology,
the first recess may have a rectangular shape in a plan view of the first recess from a light incident side.

In the solid-state imaging device according to the first aspect of the present technology,
the first recess may have a cross shape in a plan view of the first recess from a light incident side.

In the solid-state imaging device according to the first aspect of the present technology,
the first recess may have a circular shape in a plan view of the first recess from a light incident side.

In the solid-state imaging device according to the first aspect of the present technology,
the first recess may have a (x) shape in a plan view of the first recess from a light incident side.

In the solid-state imaging device according to the first aspect of the present technology,
each of the two or more steps may be formed in a predetermined direction of the first recess in a plan view of the first recess from a light incident side.

In the solid-state imaging device according to the first aspect of the present technology,
the first pixel may include a plurality of the first recesses.

In the solid-state imaging device according to the first aspect of the present technology,
a position of a center of the first pixel and a position of a center of the first recess may be different in a plan view from a light incident side.

In the solid-state imaging device according to the first aspect of the present technology,

an insulating layer and an on-chip lens may be provided in this order on the light incident surface of the semiconductor substrate,
and a material constituting the insulating layer may be different from a material constituting the on-chip lens.

Further, a second aspect of the present technology provides a solid-state imaging device including:

a semiconductor substrate;
a photoelectric conversion unit provided on the semiconductor substrate; and
a light-shielding wall provided above a light incident side of the semiconductor substrate,
in which the light-shielding wall includes a first portion having a first width extending in a direction substantially parallel to a light incident surface of the semiconductor substrate and a second portion having a second width extending in a direction substantially perpendicular to the light incident surface, the second width being smaller than the first width, and
the second portion is provided between the first portion and the semiconductor substrate.

In the solid-state imaging device according to the second aspect of the present technology,

a plurality of pixels may be arranged two-dimensionally,
at least one pixel of the plurality of pixels may include the two first portions,
an opening may be formed by the two first portions, each of the two first portions extending from each of the two pixel ends of the at least one pixel toward a central direction of the at least one pixel,
an on-chip lens may be provided above the light-shielding wall, and
a width of the opening may satisfy the following Expression (4).

$$1.22 * \lambda/n < u < W * (f-z)/f \quad \cdots \quad (4)$$

(In Expression (4), $\lambda$ is a wavelength of incident light, n is an n value of the on-chip lens, W is a size (width) of the on-chip lens, f is an F value of the on-chip lens, z is a distance from an uppermost portion on a light incident side of the on-chip lens to the opening, and u is a width of the opening.)

The solid-state imaging device according to the second aspect of the present technology may include:

a first pixel provided on the semiconductor substrate,
a photoelectric conversion unit provided in the first pixel, and
a first recess of two or more steps formed on the light incident surface of the semiconductor substrate.

In the solid-state imaging device according to the second aspect of the present technology, a difference in height between the successive steps in the first recess may satisfy the following Expression (1).

$$\text{Log }(2)/\alpha < x < 0.6 \text{ }\mu\text{m} \quad \cdots \quad (1)$$

(In Expression (1), $\alpha$ is a light absorption coefficient of the semiconductor substrate, and x is a difference in height between the successive steps.)

In the solid-state imaging device according to the second aspect of the present technology,

an on-chip lens may be provided on the light incident surface of the semiconductor substrate, and
a width of a widest portion of an entrance on a light incident side of the first recess in a cross-sectional view may satisfy the following Expression (2).

$$1.22 * \lambda/n < y < W * (f-z)/f \quad \cdots \quad (2)$$

(In Expression (2), $\lambda$ is a wavelength of incident light, n is an n value of the on-chip lens, W is a size (width) of the on-chip lens, f is an F value of the on-chip lens, z is a distance from an uppermost portion on a light incident side of the on-chip lens to the widest portion of the entrance on the light incident side of the first recess, and y is a width of the widest portion of the entrance on the light incident side of the first recess.)

The solid-state imaging device according to the second aspect of the present technology may further include

a second pixel adjacent to the first pixel, and
a second recess provided in the second pixel,
in which a width of the light incident surface of the semiconductor substrate between the first recess and the second recess may satisfy the following Expression (3).

$$2 * \text{Log}(2)/\alpha < v < 1.2 \text{ }\mu\text{m} \quad \cdots \quad (3)$$

(In Expression (3), $\alpha$ is a light absorption coefficient of the semiconductor substrate, and v is a width of the light incident surface of the semiconductor substrate between the first recess and the second recess.)

In the solid-state imaging device according to the second aspect of the present technology, the first recess may have a rectangular shape in a plan view of the first recess from a light incident side.

In the solid-state imaging device according to the second aspect of the present technology, the first recess may have a cross shape in a plan view of the first recess from a light incident side.

In the solid-state imaging device according to the second aspect of the present technology, the first recess may have a circular shape in a plan view of the first recess from a light incident side.

In the solid-state imaging device according to the second aspect of the present technology, the first recess may have a (x) shape in a plan view of the first recess from a light incident side.

In the solid-state imaging device according to the second aspect of the present technology, each of the two or more steps may be formed in a predetermined direction of the first recess in a plan view of the first recess from a light incident side.

In the solid-state imaging device according to the second aspect of the present technology, the first pixel may include a plurality of the first recesses.

In the solid-state imaging device according to the second aspect of the present technology,
a position of a center of the first pixel and a position of a center of the first recess may be different in a plan view from a light incident side.

In the solid-state imaging device according to the second aspect of the present technology,

an insulating layer and an on-chip lens may be provided in this order on the light incident surface of the semiconductor substrate,
and a material constituting the insulating layer may be different from a material constituting the on-chip lens.

A third aspect of the present technology provides an electronic device on which any one of the solid-state imaging devices according to the first and second aspects of the present technology is mounted.

According to the present technology, it is possible to further improve the performance of the solid-state imaging device. It is to be noted that the effects described herein are not necessarily limitative, and any of the effects described in the present disclosure may be exhibited.

BRIEF DESCRIPTION OF DRAWINGS

Fig. 1 is a view for describing a configuration of a solid-state imaging device to which the present technology is applied.
Fig. 2 is a diagram for explaining wavelength dependency of silicon (Si) reflectance.
Fig. 3 is a view for describing a configuration of a solid-state imaging device of a first embodiment to which the present technology is applied.
Fig. 4 is a view for describing a configuration of a solid-state imaging device of a second embodiment to which the present technology is applied.
Fig. 5 is a view depicting a configuration example of a solid-state imaging device of a third embodiment to which the present technology is applied.
Fig. 6 is a view depicting a configuration example of a solid-state imaging device of a fourth embodiment to which the present technology is applied.
Fig. 7 is a view depicting a configuration example of a solid-state imaging device of a fifth embodiment to which the present technology is applied.
Fig. 8 is a view depicting a configuration example of a solid-state imaging device of a sixth embodiment to which the present technology is applied.
Fig. 9 is a view depicting a configuration example of a solid-state imaging device of a seventh embodiment to which the present technology is applied.
Fig. 10 is a view for describing a configuration of a solid-state imaging device of an eighth embodiment to which the present technology is applied.
Fig. 11 is a view depicting a configuration example of a solid-state imaging device of a ninth embodiment to which the present technology is applied.
Fig. 12 is a view depicting a light intensity distribution, a light absorption distribution, and a quantum efficiency (QE) calculation result at $\lambda$ = 193 nm.
Fig. 13 is a view depicting a usage example of the solid-state imaging device of the first to ninth embodiments to which the present technology is applied.
Fig. 14 is a functional block diagram of an example of an electronic device of a tenth embodiment to which the present technology is applied.
Fig. 15 is a view depicting an example of a schematic configuration of an endoscopic surgery system.
Fig. 16 is a block diagram depicting an example of a functional configuration of a camera head and a camera control unit (CCU).
Fig. 17 is a block diagram depicting an example of a schematic configuration of a vehicle control system.
Fig. 18 is an explanatory view depicting an example of an installation position of a vehicle exterior information detection section and an imaging section.

MODE FOR CARRYING OUT THE INVENTION

Hereinafter, preferred embodiments for implementing the present technology will be described. An embodiment hereinafter described depicts an example of a representative embodiment of the present technology, and the scope of the present technology is not narrowed by this. It is to be noted that, unless otherwise specified, in the drawings, "upper" means an upward direction or an upper side in the drawing, "lower" means a downward direction or a lower side in the drawing, "left" means a leftward direction or a left side in the drawing, and "right" means a rightward direction or a right side in the drawing. In addition, in the drawings, the same or equivalent elements or members are denoted by the same reference signs, and redundant description will be omitted.

The description will be given in the following order.

1. Outline of Present Technology
2. First Embodiment (Example 1 of Solid-State Imaging Device)
3. Second Embodiment (Example 2 of Solid-State Imaging Device)
4. Third Embodiment (Example 3 of Solid-State Imaging Device)
5. Fourth Embodiment (Example 4 of Solid-State Imaging Device)
6. Fifth Embodiment (Example 5 of Solid-State Imaging Device)
7. Sixth Embodiment (Example 6 of Solid-State Imaging Device)
8. Seventh Embodiment (Example 7 of Solid-State Imaging Device)
9. Eighth Embodiment (Example 8 of Solid-State Imaging Device)
10. Ninth Embodiment (Example 9 of Solid-State Imaging Device)
11. Tenth Embodiment (Example of Electronic Device)
12. Usage Example of Solid-State Imaging Device to which Present Technology is Applied
13. Application Example to Endoscopic Surgery System
14. Application Example to Mobile Body

<1. Outline of Present Technology>

The outline of the present technology will be described.

For example, in a UV region, since silicon (Si), which is typical as a light receiving element, has a high light absorption coefficient, silicon (Si) is likely to cause reflection, and as a result, a quantum efficiency (QE) may be lowered, and a reflection loss may be large.

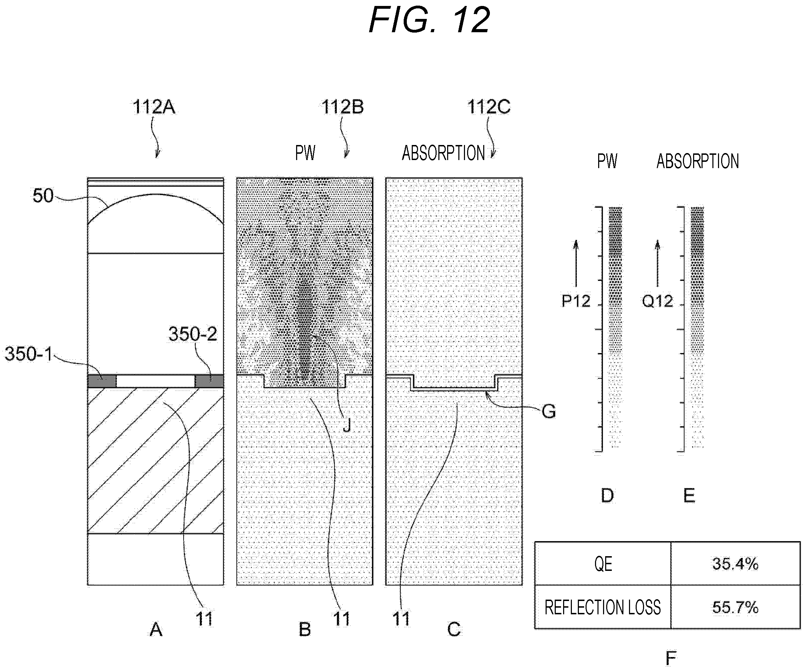

The above will be described with reference to Fig. 12. Fig. 12 is a view depicting a light intensity distribution, a light absorption distribution, and a QE calculation result at $\lambda$ = 193 nm.

More specifically, Fig. 12A is a diagram depicting a configuration example of a solid-state imaging device (solid-state imaging device 112A) used to describe the light intensity distribution (power distribution of light) and the light absorption distribution, Fig. 12B is a diagram depicting a configuration example of a solid-state imaging device (solid-state imaging device 112B) used to describe the light intensity distribution (power distribution of light), Fig. 12C is a diagram depicting a configuration example of a solid-state imaging device (solid-state imaging device 112C) used to describe the light absorption distribution, Fig. 12D is a diagram for describing a light intensity level (power of light) (the direction of an arrow P12 indicates that the light intensity increases), Fig. 12E is a diagram for describing a light absorption level (the direction of an arrow Q12 indicates that the absorption level increases), and Fig. 12F is a diagram showing a result of QE and a reflection loss of the solid-state imaging device.

The solid-state imaging device 112A includes an on-chip lens 50, light-shielding walls 350-1 and 350-2 (both ends of the pixel), and a semiconductor substrate (silicon (Si) substrate) 22A in order from the light incident side (from the upper side in Fig. 12A). As depicted in Fig. 12B, since the light in the UV region is condensed, the vicinity of the middle on a semiconductor substrate (silicon (Si) substrate) 22B is a region (J region) having a high light intensity, but it is difficult to cause a semiconductor substrate (silicon (Si) substrate) 22C to absorb the light in the UV region (reference sign G in Fig. 12C indicates a light absorption region). As a result, as shown in Fig. 12F, the QE is 35.4%, and the reflection loss is 55.7%.

The present technology has been made in view of such a situation. As will be described later, the present technology can further improve the sensitivity by increasing the surface area of the light receiving element (semiconductor substrate (photoelectric conversion unit)) to increase a region capable of absorbing light (for example, light in the UV region).

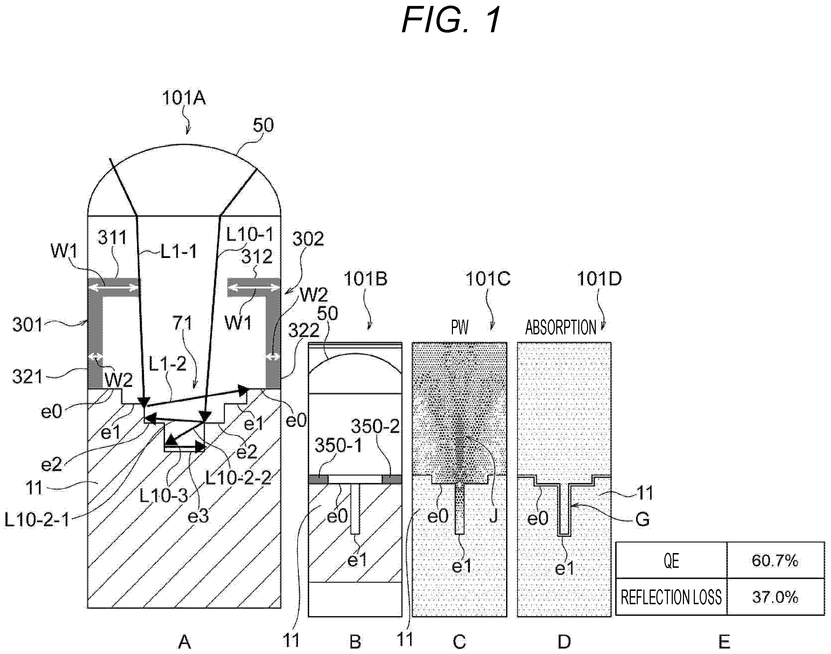

Next, the description will be given with reference to Fig. 1. Fig. 1 is a view for describing a configuration of a solid-state imaging device according to the present technology.

More specifically, Fig. 1A is a cross-sectional view depicting a configuration example of one pixel of a solid-state imaging device (solid-state imaging device 101A) according to the present technology, Fig. 1B is a diagram depicting a configuration example of a solid-state imaging device (solid-state imaging device 101B) used to describe a light intensity distribution (power distribution of light) and a light absorption distribution, Fig. 1C is a diagram depicting a configuration example of a solid-state imaging device (solid-state imaging device 101C) used to describe the light intensity distribution (power distribution of light), Fig. 1D is a diagram depicting a configuration example of a solid-state imaging device (solid-state imaging device 101D) used to describe the light absorption distribution, and Fig. 1E is a diagram depicting a QE and a result of a reflection loss of the solid-state imaging device to which the present technology is applied.

The solid-state imaging device 101A depicted in Fig. 1A includes a semiconductor substrate 11 and a photoelectric conversion unit (not depicted, but is, for example, a photodiode (PD), the same applies hereinafter) provided on the semiconductor substrate 11, and a recess 71 of two or more steps (three steps in Fig. 1A) formed on the surface on the light incident side (the upper side in Fig. 1A) of the semiconductor substrate 11.

In the solid-state imaging device 101A, two light-shielding walls 301 and 302 are provided above the light incident side of the semiconductor substrate 11. Then, an on-chip lens 50 is provided above the light incident side of the two light-shielding walls 301 and 302.

The material constituting the light-shielding walls 301 and 302 is not particularly limited and may be any material as long as the material reflects light (for example, light in the UV region). For example, aluminum (Al) or silver (Ag) is suitable. Further, tungsten (W) may be used as a material constituting the light-shielding walls 301 and 302, but since tungsten (W) has a property of easily absorbing light, caution may be required when tungsten (W) is used.

The light-shielding wall 301 includes a first portion 311 having a first width W1 extending in a direction substantially parallel to the light incident surface of the semiconductor substrate 11 and a second portion 321 having a second width W2 extending in a direction substantially perpendicular to the light incident surface, the second width W2 being smaller than the first width W1. The second portion 321 is provided between the first portion 311 and the semiconductor substrate 11.

The light-shielding wall 302 includes a first portion 312 having a first width W1 extending in a direction substantially parallel to the light incident surface of the semiconductor substrate 11 and a second portion 322 having a second width W2 extending in a direction substantially perpendicular to the light incident surface, the second width W2 being smaller than the first width W1. The second portion 322 is provided between the first portion 312 and the semiconductor substrate 11.

The first portion 311 extends from the left end of the pixel toward the center of the pixel (extends in the rightward in Fig. 1A), the first portion 312 extends from the right end of the pixel toward the center of the pixel (extends in the leftward in Fig. 1A), and an opening is formed by the two first portions 311 and 312.

Incident light L1-1 (for example, light in the UV region) condensed by the on-chip lens 50 passes through the opening described above, is reflected near a first step e1 on the left side of the recess 71, becomes reflected light L1-2, and is absorbed (photoelectrically converted) by the semiconductor substrate 11. Incident light L10-1 (for example, light in the UV region) passes through the opening described above and is reflected by a second step e2 on the right side of the recess 71 to become reflected light L10-2-1 and reflected light L10-2-2. Thereafter, the reflected light L10-2-1 is absorbed (photoelectrically converted) by the semiconductor substrate 11, and the reflected light L10-2-2 is further reflected between the second step e2 and a third step e3 on the left side of the recess 71 to become reflected light L10-3 and is absorbed by (photoelectrically converted) the semiconductor substrate 11. As described above, by reflecting incident light (for example, light in the UV region) a plurality of times, the incident light (for example, light in the UV region) can be absorbed by the semiconductor substrate 11.

The solid-state imaging device 101B includes an on-chip lens 50, light-shielding walls 350-1 and 350-2 (both end portions of the pixel), and a semiconductor substrate (silicon (Si) substrate) 11B having a recess in order from the light incident side (from the upper side in Fig. 1). As depicted in Fig. 1C, since the light in the UV region is condensed, the vicinity of the middle on a semiconductor substrate (silicon (Si) substrate) 11C is a region (J region) where the light intensity is high. The light in the UV region is absorbed along the recess shape of a semiconductor substrate (silicon (Si) substrate) 11D (reference sign G in Fig. 1D indicates a light absorption region). As a result, as shown in Fig. 1E, since the QE is 60.7% and the reflection loss is 37.0%, the QE of the solid-state imaging device 101B is improved with respect to the QE of the solid-state imaging device 112A, and the reflection loss of the solid-state imaging device 101B is reduced with respect to the reflection loss of the solid-state imaging device 112A.

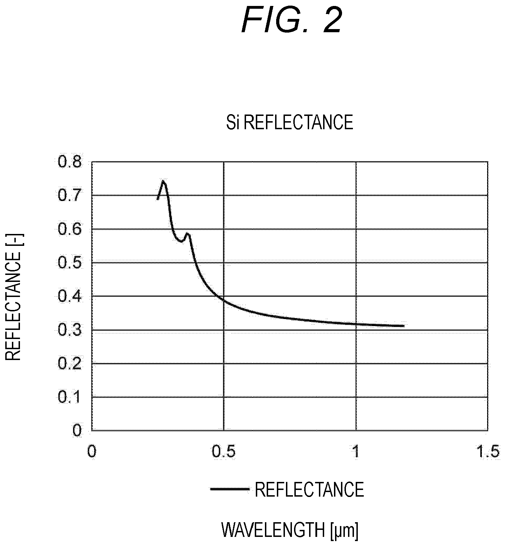

This will be explained with reference to Fig. 2. Fig. 2 is a diagram for explaining wavelength dependency of the reflectance of silicon (Si). The vertical axis in Fig. 2 represents reflectance [-], and the horizontal axis in Fig. 2 represents wavelength [um].

As shown in Fig. 2, since the reflectance is large at a wavelength of, for example, 500 nm or less as the maximum wavelength, particularly at a wavelength of 400 nm or less, the present technology is useful by particularly exerting an effect on light having a wavelength of, for example, 500 nm or less, particularly at a wavelength of 400 nm or less as the maximum wavelength.

Next, preferred embodiments for carrying out the present technology will be described in detail and specifically with reference to the drawings.

<2. First embodiment (Example 1 of Solid-State Imaging Device)>

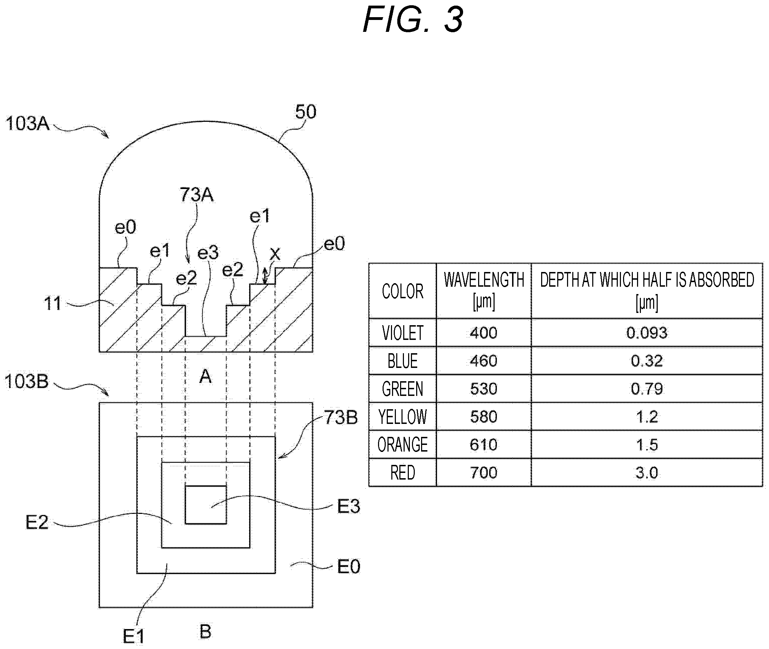

A solid-state imaging device of a first embodiment (example 1 of solid-state imaging device) according to the present technology will be described with reference to Fig. 3.

Fig. 3 is a view for describing a configuration example of the solid-state imaging device (solid-state imaging device 103) according to the first embodiment of the present technology.

More specifically, Fig. 3A is a cross-sectional view depicting a configuration example for one pixel of a solid-state imaging device (solid-state imaging device 103A) according to the first embodiment of the present technology, and Fig. 3B is a top view (plan layout view (plan view) from the light incident side) depicting a configuration example for one pixel of a solid-state imaging device (solid-state imaging device 103B) according to the first embodiment of the present technology.

The solid-state imaging device 103A depicted in Fig. 3A includes a semiconductor substrate 11, a photoelectric conversion unit (not depicted) provided on the semiconductor substrate 11, and a recess 73A of two or more steps (three steps in Fig. 3A) formed on a surface on the light incident side (upper side in Fig. 3A) of the semiconductor substrate 11. It is to be noted that, although not depicted, a plurality of the recesses 73A may be included in one pixel.

Then, in the solid-state imaging device 103A, an on-chip lens 50 is provided above the light incident side of the semiconductor substrate 11.

As depicted in Fig. 3A, in the recess 73A, the semiconductor substrate 11 is dug in the depth direction (direction opposite to the light incident side) to form a first step e1, a second step e2, and a third step e3. It is to be noted that reference sign e0 is a zeroth step in which the semiconductor substrate 11 is not dug.

As depicted in Fig. 3B, a recess 73B included in the solid-state imaging device 103B in a plan view has a rectangular shape. Specifically, a first step E1 corresponding to the first step e1 and a second step E2 corresponding to the second step e2 are formed in a rectangular shape with a predetermined width along the inner periphery of the pixel, and a third step E3 corresponding to the third step e3 is rectangular. It is to be noted that a zeroth step e0 corresponds to a zeroth step E0.

In the solid-state imaging device 103A, a difference x in height between successive steps in the recess 73A (a difference in height between the zeroth step e0 and the first step e1 in Fig. 3A) can satisfy the following Expression (1).

$$\mathrm{Log}\ (2)/\alpha < x < 0.6\ \mu\mathrm{m} \cdots (1)$$

In Expression (1), $\alpha$ is a light absorption coefficient of the semiconductor substrate 11, and x is a difference in height between the successive steps as described above. Although not depicted, x may be a difference in height between the first step e1 and the second step e2, or may be a difference in height between the second step e2 and the third step e3. Log $(2)/\alpha$ represents a depth at which half of light (for example, light in the UV region) is absorbed, and 0.6 um is a half value of a 500 nm wavelength with reference to the table shown in Fig. 3.

As described above, the content described for the solid-state imaging device of the first embodiment (example 1 of the solid-state imaging device device) according to the present technology can be applied to the solid-state imaging device of the second to ninth embodiments according to the present technology as described later as long as there is no particular technical contradiction.

<3. Second Embodiment (Example 2 of Solid-State Imaging Device)>

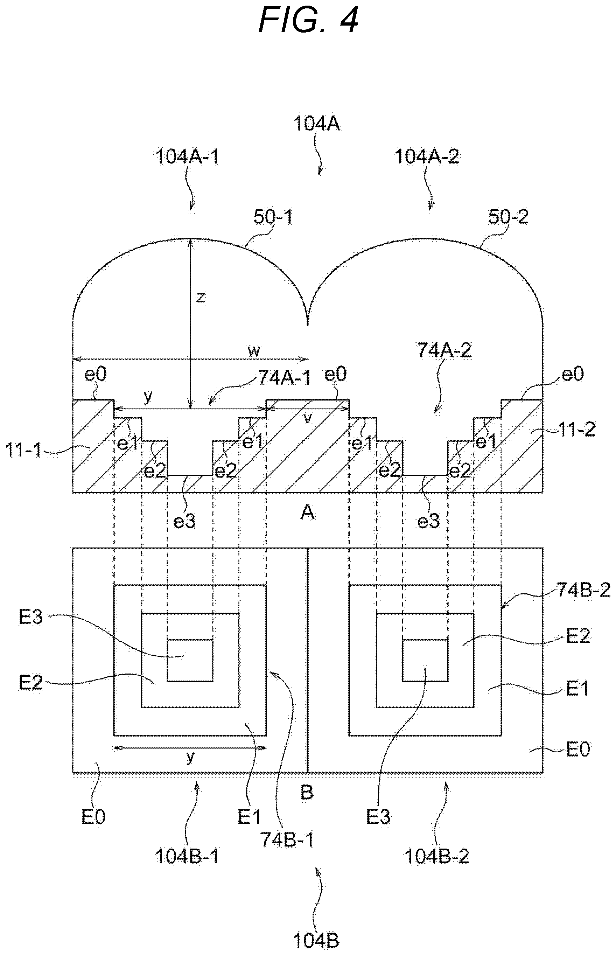

A solid-state imaging device of a second embodiment (example 2 of solid-state imaging device) according to the present technology will be described with reference to Fig. 4.

Fig. 4 is a view for describing a configuration example of the solid-state imaging device (solid-state imaging device 104) according to the second embodiment of the present technology.

More specifically, Fig. 4A is a cross-sectional view depicting a configuration example for two pixels of a solid-state imaging device (solid-state imaging device 104A) according to the second embodiment of the present technology, and Fig. 4B is a top view (plan layout view (plan view) from the light incident side) depicting a configuration example for two pixels of a solid-state imaging device (solid-state imaging device 104B) according to the second embodiment of the present technology.

The solid-state imaging device 104A depicted in Fig. 4A includes two pixels of a pixel 104A-1 and a pixel 104A-2. The pixel 104A-1 includes a semiconductor substrate 11-1, a photoelectric conversion unit (not depicted) provided on the semiconductor substrate 11-1, and a recess 74A-1 of two or more steps (three steps in Fig. 4A) formed on a surface on the light incident side (upper side in Fig. 4A) of the semiconductor substrate 11-1. On the other hand, the pixel 104A-2 includes a semiconductor substrate 11-2, a photoelectric conversion unit (not depicted) provided on the semiconductor substrate 11-2, and a recess 74A-2 of two or more steps (three steps in Fig. 4A) formed on a surface on the light incident side (upper side in Fig. 4A) of the semiconductor substrate 11-2.

Then, in the pixel 104A-1 of the solid-state imaging device 104A, an on-chip lens 50-1 is provided above the light incident side of the semiconductor substrate 11-1, and in the pixel 104A-2, an on-chip lens 50-2 is provided above the light incident side of the semiconductor substrate 11-2.

As depicted in Fig. 4A, in the recess 74A-1, the semiconductor substrate 11-1 is dug in the depth direction (direction opposite to the light incident side) to form a first step e1, a second step e2, and a third step e3. It is to be noted that reference sign e0 is a zeroth step in which the semiconductor substrate 11-1 is not dug.

Similarly, in the recess 74A-2, the semiconductor substrate 11-2 is dug in the depth direction (direction opposite to the light incident side) to form a first step e1, a second step e2, and a third step e3. It is to be noted that reference sign e0 is a zeroth step in which the semiconductor substrate 11-2 is not dug.

As depicted in Fig. 4B, in a plan view, a recess 74B-1 included in the solid-state imaging device 104B (pixel 104B-1) has a rectangular shape. Specifically, a first step E1 corresponding to the first step e1 and a second step E2 corresponding to the second step e2 are formed in a rectangular shape with a predetermined width along the inner periphery of the pixel 104B-1, and a third step E3 corresponding to the third step e3 is rectangular. It is to be noted that a zeroth step e0 corresponds to a zeroth step E0 .

Similarly, in a plan view, a recess 74B-2 included in the solid-state imaging device 104B (pixel 104B-2) has a rectangular shape. Specifically, a first step E1 corresponding to the first step e1 and a second step E2 corresponding to the second step e2 are formed in a rectangular shape with a predetermined width along the inner periphery of the pixel 104B-2, and a third step E3 corresponding to the third step e3 is rectangular. It is to be noted that a zeroth step e0 corresponds to a zeroth step E0.

In the solid-state imaging device 104 (solid-state imaging devices 104A and 104B), the width, (which may also be referred to as a "processed portion width"), of the entrance on the light incident side of the recess 74A-1 in a cross-sectional view can satisfy the following Expression (2).

$$1.22 * \lambda/n < y < W * (f-z)/f \cdots (2)$$

In Expression (2), $\lambda$ is the wavelength of the incident light, n is the n value of the on-chip lens 50-1, W is the size (width) of the on-chip lens 50-1, f is the F value of the on-chip lens 50-1, z is the distance from the uppermost portion on the light incident side of the on-chip lens 50 to the entrance on the light incident side of the recess 74A-1, and y is the width of the entrance on the light incident side of the recess 74-1.

Further, in the solid-state imaging device 104 (solid-state imaging devices 104A and 104B), the widths on the light incident side, (which may be referred to as a "light receiving portion width"), of the semiconductor substrates 11-1 and 11-2 between the recess 74A-1 and the recess 74A-2 can satisfy the following Expression (3).

$$2 * Log(2)/\alpha < v < 1.2 \ \mu m \cdots (3)$$

In Expression (3), $\alpha$ is the light absorption coefficient of the semiconductor substrates 11-1 and 11-2, and v is the width (light receiving portion width) on the light incident side of the semiconductor substrates 11-1 and 11-2 between the two recesses 74A-1 and 74A-2 as described above.

As described above, the content described for the solid-state imaging device of the second embodiment (example 2 of solid-state imaging device) according to the present technology can be applied to the above-described solid-state imaging device of the first embodiment according to the present technology and the solid-state imaging devices of the third to ninth embodiments according to the present technology as described later as long as there is no particular technical contradiction.

<4. Third embodiment (Example 3 of Solid-State Imaging Device)>

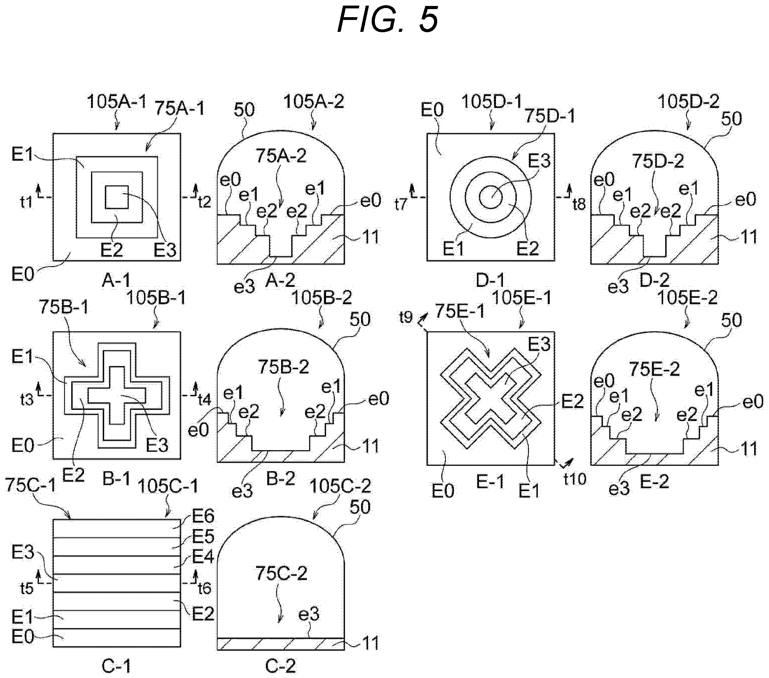

A solid-state imaging device of a third embodiment (example 3 of solid-state imaging device) according to the present technology will be described with reference to Fig. 5.

Fig. 5 is a view depicting a configuration example of solid-state imaging devices (solid-state imaging devices 105A, 105B, 105C, 105D, and 105E) according to the third embodiment of the present technology.

Fig. 5A-1 is a top view (plan layout view (plan view) from the light incident side) depicting a configuration example of one pixel of a solid-state imaging device (solid-state imaging device 105A-1) according to the third embodiment of the present technology, and Fig. 5A-2 is a cross-sectional view depicting a configuration example of one pixel of a solid-state imaging device (solid-state imaging device 105A-2) according to the third embodiment of the present technology according to a t1-t2 line depicted in Fig. 5A-1.

The solid-state imaging device 105A-2 depicted in Fig. 5A-2 includes a semiconductor substrate 11, a photoelectric conversion unit (not depicted) provided on the semiconductor substrate 11, and a recess 75A-2 of two or more steps (three steps in Fig. 5A-2) formed on a surface on the light incident side (upper side in Fig. 5A-2) of the semiconductor substrate 11.

Then, in the solid-state imaging device 105A-2, an on-chip lens 50 is provided above the light incident side of the semiconductor substrate 11.

As depicted in Fig. 5A-2, in the recess 74A-2, the semiconductor substrate 11 is dug in the depth direction (direction opposite to the light incident side) to form a first step e1, a second step e2, and a third step e3. It is to be noted that reference sign e0 is a zeroth step in which the semiconductor substrate 11 is not dug.

As depicted in Fig. 5A-1, in a plan view, a recess 75A-1 included in the solid-state imaging device 105A-1 has a rectangular shape. Specifically, a first step E1 corresponding to the first step e1 and a second step E2 corresponding to the second step e2 are formed with a predetermined width along the inner periphery of the pixel, and a third step E3 corresponding to the third step e3 has a rectangular shape. It is to be noted that a zeroth step e0 corresponds to a zeroth step E0.

Fig. 5B-1 is a top view (plan layout view (plan view) from the light incident side) depicting a configuration example of one pixel of a solid-state imaging device (solid-state imaging device 105B-1) according to the third embodiment of the present technology, and Fig. 5B-2 is a cross-sectional view depicting a configuration example of one pixel of a solid-state imaging device (solid-state imaging device 105B-2) according to the third embodiment of the present technology according to a t3-t4 line depicted in Fig. 5B-1.

The solid-state imaging device 105B-2 depicted in Fig. 5B-2 includes a semiconductor substrate 11, a photoelectric conversion unit (not depicted) provided on the semiconductor substrate 11, and a recess 75B-2 of two or more steps (three steps in Fig. 5B-2) formed on a surface on the light incident side (upper side in Fig. 5B-2) of the semiconductor substrate 11.

Then, in the solid-state imaging device 105B-2, an on-chip lens 50 is provided above the light incident side of the semiconductor substrate 11.

As depicted in Fig. 5B-2, in the recess 75B-2, the semiconductor substrate 11 is dug in the depth direction (direction opposite to the light incident side) to form a first step e1, a second step e2, and a third step e3. It is to be noted that reference sign e0 is a zeroth step in which the semiconductor substrate 11 is not dug.

As depicted in Fig. 5B-1, in a plan view, a recess 75B-1 of the solid-state imaging device 105B-1 has a cross shape. Specifically, a first step E1 corresponding to the first step e1, a second step E2 corresponding to the second step e2, and a third step E3 corresponding to the third step e3 have a cross shape. It is to be noted that a zeroth step e0 corresponds to a zeroth step E0.

Fig. 5C-1 is a top view (plan layout view (plan view) from the light incident side) depicting a configuration example of one pixel of a solid-state imaging device (solid-state imaging device 105C-1) according to the third embodiment of the present technology, and Fig. 5C-2 is a cross-sectional view depicting a configuration example of one pixel of a solid-state imaging device (solid-state imaging device 105C-2) according to the third embodiment of the present technology according to a t5-t6 line depicted in Fig. 5C-1.

The solid-state imaging device 105C-2 depicted in Fig. 5C-2 includes a semiconductor substrate 11, a photoelectric conversion unit (not depicted) provided on the semiconductor substrate 11, and one step 75C-2 constituting a recess 75C-1 of two or more steps (seven steps in Fig. 5C-1) formed on a surface on the light incident side (upper side in Fig. 5C-2) of the semiconductor substrate 11.

Then, in the solid-state imaging device 105C-2, an on-chip lens 50 is provided above the light incident side of the semiconductor substrate 11.

As depicted in Fig. 5C-1, in a plan view, each of the two or more steps (six steps of E1 to E6 in Fig. 5C-1) of the recess 75C-1 included in the solid-state imaging device 105C-1 is formed in the longitudinal direction of the recess 75C-1 (vertical direction of Fig. 5C-1). It is to be noted that reference sign E0 is a zeroth step in which the semiconductor substrate is not dug. Then, although not depicted, each of the two or more steps may be formed in the lateral direction of the recess 75C-1 (horizontal direction in Fig. 5C-1). Further, the heights of the six steps E1 to E6 may gradually increase, decrease, or may be random.

Fig. 5D-1 is a top view (plan layout view (plan view) from the light incident side) depicting a configuration example of one pixel of a solid-state imaging device (solid-state imaging device 105D-1) according to the third embodiment of the present technology, and Fig. 5D-2 is a cross-sectional view depicting a configuration example of one pixel of a solid-state imaging device (solid-state imaging device 105D-2) according to the third embodiment of the present technology according to a t7-t8 line depicted in Fig. 5D-1.

The solid-state imaging device 105D-2 depicted in Fig. 5D-2 includes a semiconductor substrate 11, a photoelectric conversion unit (not depicted) provided on the semiconductor substrate 11, and a recess 75D-2 of two or more steps (three steps in Fig. 5D-2) formed on a surface on the light incident side (upper side in Fig. 5D-2) of the semiconductor substrate 11.

Then, in the solid-state imaging device 105D-2, an on-chip lens 50 is provided above the light incident side of the semiconductor substrate 11.

As depicted in Fig. 5D-2, in the recess 75D-2, the semiconductor substrate 11 is dug in the depth direction (direction opposite to the light incident side) to form a first step e1, a second step e2, and a third step e3. It is to be noted that reference sign e0 is a zeroth step in which the semiconductor substrate 11 is not dug.

As depicted in Fig. 5D-1, in a plan view, a recess 75D-1 included in the solid-state imaging device 105D-1 has a circular shape (may have an elliptical shape). Specifically, a first step E1 corresponding to the first step e1 and a second step E2 corresponding to the second step e2 are formed in a curved shape with a predetermined width along the inner periphery of the pixel, and a third step E3 corresponding to the third step e3 has a circular shape (may have an elliptical shape). It is to be noted that a zeroth step e0 corresponds to a zeroth step E0.

Fig. 5E-1 is a top view (plan layout view (plan view) from the light incident side) depicting a configuration example of one pixel of a solid-state imaging device (solid-state imaging device 105E-1) according to the third embodiment of the present technology, and Fig. 5E-2 is a cross-sectional view depicting a configuration example of one pixel of a solid-state imaging device (solid-state imaging device 105E-2) according to the third embodiment of the present technology according to a t9-t10 line depicted in Fig. 5E-1.

The solid-state imaging device 105E-2 depicted in Fig. 5E-2 includes a semiconductor substrate 11, a photoelectric conversion unit (not depicted) provided on the semiconductor substrate 11, and a recess 75E-2 of two or more steps (three steps in Fig. 5E-2) formed on a surface on the light incident side (upper side in Fig. 5E-2) of the semiconductor substrate 11.

Then, in the solid-state imaging device 105E-2, an on-chip lens 50 is provided above the light incident side of the semiconductor substrate 11.

As depicted in Fig. 5E-2, in the recess 75E-2, the semiconductor substrate 11 is dug in the depth direction (direction opposite to the light incident side) to form a first step e1, a second step e2, and a third step e3. It is to be noted that reference sign e0 is a zeroth step in which the semiconductor substrate 11 is not dug.

As depicted in Fig. 5E-1, in a plan view, a recess 75E-1 of the solid-state imaging device 105E-1 has a (x) shape. Specifically, a first step E1 corresponding to the first step e1, a second step E2 corresponding to the second step e2, and a third step E3 corresponding to the third step e3 have a (x) shape. It is to be noted that a zeroth step e0 corresponds to a zeroth step E0.

As described above, the content described for the solid-state imaging device of the third embodiment (example 3 of solid-state imaging device) according to the present technology can be applied to the above-described solid-state imaging devices of the first to second embodiments according to the present technology and the solid-state imaging devices of the fourth to ninth embodiments according to the present technology as described later as long as there is no particular technical contradiction.

<5. Fourth embodiment (Example 4 of solid-state imaging device)>

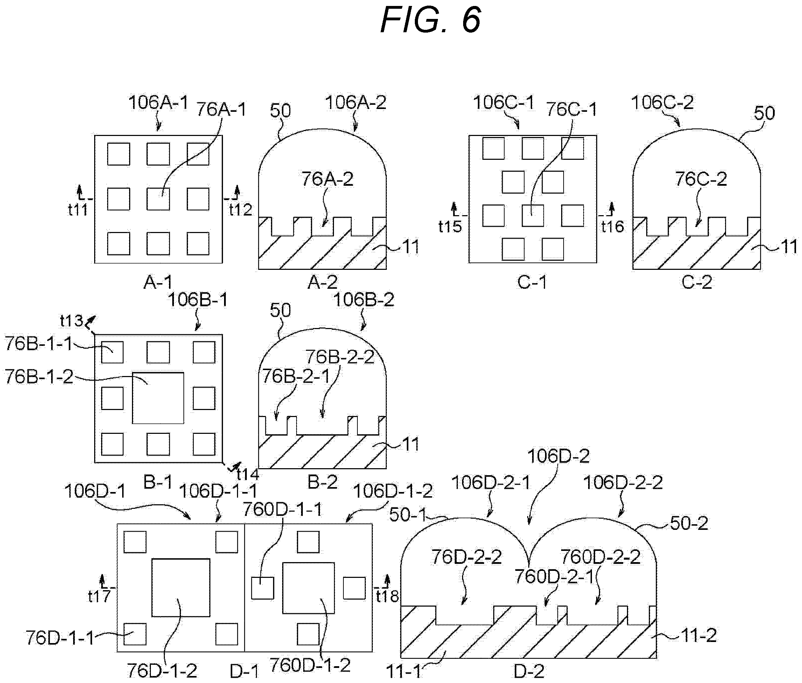

A solid-state imaging device of a fourth embodiment (example 4 of solid-state imaging device) according to the present technology will be described with reference to Fig. 6.

Fig. 6 is a view depicting a configuration example of solid-state imaging devices (solid-state imaging devices 106A, 106B, 106C, and 106D) according to the fourth embodiment of the present technology.

Fig. 6A-1 is a top view (plan layout view (plan view) from the light incident side) depicting a configuration example of one pixel of a solid-state imaging device (solid-state imaging device 106A-1) according to the fourth embodiment of the present technology, and Fig. 6A-2 is a cross-sectional view depicting a configuration example of one pixel of a solid-state imaging device (solid-state imaging device 106A-2) according to the fourth embodiment of the present technology according to a t11-t12 line depicted in Fig. 6A-1.

The solid-state imaging device 106A-2 depicted in Fig. 6A-2 includes a semiconductor substrate 11, a photoelectric conversion unit (not depicted) provided on the semiconductor substrate 11, and a recess 76A-2 of one step formed on a surface on the light incident side (upper side in Fig. 6A-2) of the semiconductor substrate 11.

In Fig. 6A-2, in addition to the recess 76A-2, a recess having the same surface area (bottom area and side surface area (step depth)) as the surface area (bottom area and side surface area (step depth)) of the recess 76A-2 is formed at each of the left and right positions of the recess 76A-2.

Then, in the solid-state imaging device 106A-2, an on-chip lens 50 is provided above the light incident side of the semiconductor substrate 11.

As depicted in Fig. 6A-1, in a plan view, a plurality of (nine in one pixel in Fig. 6A-1) rectangular recesses 76A-1 of one step included in the solid-state imaging device 106A-1 is arranged, and in Fig. 6A-1, three recesses are arranged in the first row (horizontal direction in the drawing), three recesses are arranged in the second row, and three recesses are arranged in the third row. The arrangement interval (periodicity) of the plurality of recesses 76A-1 may be any interval, but the flare is less likely to occur as the arrangement interval (periodicity) is smaller.

Fig. 6B-1 is a top view (plan layout view (plan view) from the light incident side) depicting a configuration example of one pixel of a solid-state imaging device (solid-state imaging device 106B-1) according to the fourth embodiment of the present technology, and Fig. 6B-2 is a cross-sectional view depicting a configuration example of one pixel of a solid-state imaging device (solid-state imaging device 106B-2) according to the fourth embodiment of the present technology according to a t13-t14 line depicted in Fig. 6B-1.

The solid-state imaging device 106B-2 depicted in Fig. 6B-2 includes a semiconductor substrate 11, a photoelectric conversion unit (not depicted) provided on the semiconductor substrate 11, and a recess 76B-2-1 of one step and a recess 76B-2-2 of one step formed on a surface on the light incident side (upper side in Fig. 6A-2) of the semiconductor substrate 11.

In Fig. 6B-2, a recess having the same surface area (bottom area and side surface area (step depth)) as the surface area (bottom area and side surface area (step depth)) of the recess 76B-2-1 is formed at the right position of the recess 76B-2-2. Then, the surface area of the recess 76B-2-1 is smaller than the surface area of the recess 76B-2-2. That is, the side surface area (step depth) of the recess 76B-2-1 is the same as the side surface area (step depth) of the recess 76B-2-2, but the bottom area of the recess 76B-2-1 is smaller than the bottom area of the recess 76B-2-2.

Then, in the solid-state imaging device 106B-2, an on-chip lens 50 is provided above the light incident side of the semiconductor substrate 11.

As depicted in Fig. 6B-1, in a plan view, a plurality of (eight in one pixel in Fig. 6B-1) rectangular one-step recesses 76B-1-1 included in the solid-state imaging device 106B-1 is arranged around the inner periphery of the pixel, and the rectangular one-step recess 76B-1-2 is arranged at the central portion of the pixel. The area (surface area) of the rectangular recess 76B-1-2 is larger than the area (surface area) of the rectangular recess 76B-1-1. The depth (height) of the step of the rectangular one-step recess 76B-1-1 and the depth (height) of the step of the rectangular one-step recess 76B-1-2 may be substantially the same or different.

Fig. 6C-1 is a top view (plan layout view (plan view) from the light incident side) depicting a configuration example of one pixel of a solid-state imaging device (solid-state imaging device 106C-1) according to the fourth embodiment of the present technology, and Fig. 6C-2 is a cross-sectional view depicting a configuration example of one pixel of a solid-state imaging device (solid-state imaging device 106C-2) according to the fourth embodiment of the present technology according to a t15-t16 line depicted in Fig. 6C-1.

The solid-state imaging device 106C-2 depicted in Fig. 6C-2 includes a semiconductor substrate 11, a photoelectric conversion unit (not depicted) provided on the semiconductor substrate 11, and a recess 76C-2 of one step formed on a surface on the light incident side (upper side in Fig. 6C-2) of the semiconductor substrate 11.

In Fig. 6C-2, in addition to the recess 76C-2, a recess having the same surface area (bottom area and side surface area (step depth)) as the surface area (bottom area and side surface area (step depth)) of the recess 76C-2 is formed at each of the left and right positions of the recess 76C-2.

Then, in the solid-state imaging device 106C-2, an on-chip lens 50 is provided above the light incident side of the semiconductor substrate 11.

As depicted in Fig. 6C-1, in a plan view, a plurality of (ten in one pixel in Fig. 6C-1) recesses 76C-1 of one step included in the solid-state imaging device 106C-1 is arranged, and in Fig. 6C-1, three recesses are arranged in the first row (horizontal direction in the drawing), two recesses are arranged in the second row, and three recesses are arranged in the third row, and four recesses are arranged in the fourth row. The arrangement interval (periodicity) of the plurality of recesses 76C-1 may be any interval, but the flare is less likely to occur as the arrangement interval (periodicity) of the plurality of recesses 76C-1 is smaller.

Fig. 6D-1 is a top view (plan layout view (plan view) from the light incident side) depicting a configuration example of two pixels of a solid-state imaging device (solid-state imaging device 106D-1) according to the fourth embodiment of the present technology, and Fig. 6D-2 is a cross-sectional view depicting a configuration example of two pixels of a solid-state imaging device (solid-state imaging device 106D-2) according to the fourth embodiment of the present technology according to a t17-t18 line depicted in Fig. 6D-1.

The solid-state imaging device 106D-2 depicted in Fig. 6D-2 includes two pixels of a pixel 106D-2-1 and a pixel 106D-2-2. The pixel 106D-2-1 includes a semiconductor substrate 11-1, a photoelectric conversion unit (not depicted) provided on the semiconductor substrate 11-1, and a recess 76D-2-2 of one step formed on a surface on the light incident side (upper side in Fig. 6D-2) of the semiconductor substrate 11-1. On the other hand, the pixel 106D-2-2 includes a semiconductor substrate 11-2, a photoelectric conversion unit (not depicted) provided on the semiconductor substrate 11-2, and a recess 760D-2-1 of one step and a recess 760D-2-2 of one step formed on a surface on the light incident side (upper side in Fig. 6D-2) of the semiconductor substrate 11-2.

In Fig. 6D-2, in the pixel 106D-2-2, a recess having the same surface area (bottom area and side surface area (step depth)) as the surface area (bottom area and side surface area (step depth)) of the recess 760D-2-1 is formed at the right position of the recess 760D-2-2. Then, the surface area of the recess 760D-2-1 is smaller than the surface area of the recess 760D-2-2. That is, the side surface area (step depth) of the recess 760D-2-1 is the same as the side surface area (step depth) of the recess 760D-2-2, but the bottom area of the recess 760D-2-1 is smaller than the bottom area of the recess 760D-2-2. Further, the surface area (bottom area and side surface area (step depth)) of the recess 76D-2-2 included in the pixel 106D-2-1 is the same as the surface area (bottom area and side surface area (step depth)) of the recess 760D-2-2 included in the pixel 106D-2-2.

Then, in the pixel 106D-2-1 of the solid-state imaging device 106D-2, an on-chip lens 50-1 is provided above the light incident side of the semiconductor substrate 11-1, and in the pixel 106D-2-2, an on-chip lens 50-2 is provided above the light incident side of the semiconductor substrate 11-2.

As depicted in Fig. 6D-1, in a plan view, a plurality of (four in one pixel in Fig. 6D-1) rectangular one-step recesses 76D-1-1 included in the solid-state imaging device 106D-1 (pixel-106D-1-1) is arranged at four corners of the pixel, and a rectangular one-step recess 76D-1-2 is arranged at the central portion of the pixel. The area (surface area) of the rectangular recess 76D-1-2 is larger than the area (surface area) of the rectangular recess 76D-1-1. The depth (height) of the step of the rectangular one-step recess 76D-1-1 and the depth (height) of the step of the rectangular one-step recess 76D-1-2 may be substantially the same or different.

Further, as depicted in Fig. 6D-1, in a plan view, a plurality of (four in one pixel in Fig. 6D-1) rectangular one-step recesses 760D-1-1 included in the solid-state imaging device 106D-1 (pixel-106D-1-2) is arranged, and a rectangular one-step recess 760D-1-2 is arranged at the central portion of the pixel. The four rectangular recesses 760D-1-1 are arranged to face each of the four sides of the rectangular recess 760D-1-2. The area (surface area) of the rectangular recess 760D-1-2 is larger than the area (surface area) of the rectangular recess 760D-1-1. The depth (height) of the step of the rectangular one-step recess 760D-1-1 and the depth (height) of the step of the rectangular one-step recess 760D-1-2 may be substantially the same or different.

As described above, the content described for the solid-state imaging device of the fourth embodiment (example 4 of solid-state imaging device) according to the present technology can be applied to the above-described solid-state imaging devices of the first to third embodiments according to the present technology and the solid-state imaging devices of the fifth to ninth embodiments according to the present technology as described later as long as there is no particular technical contradiction.

<6. Fifth embodiment (Example 5 of Solid-State Imaging Device)>

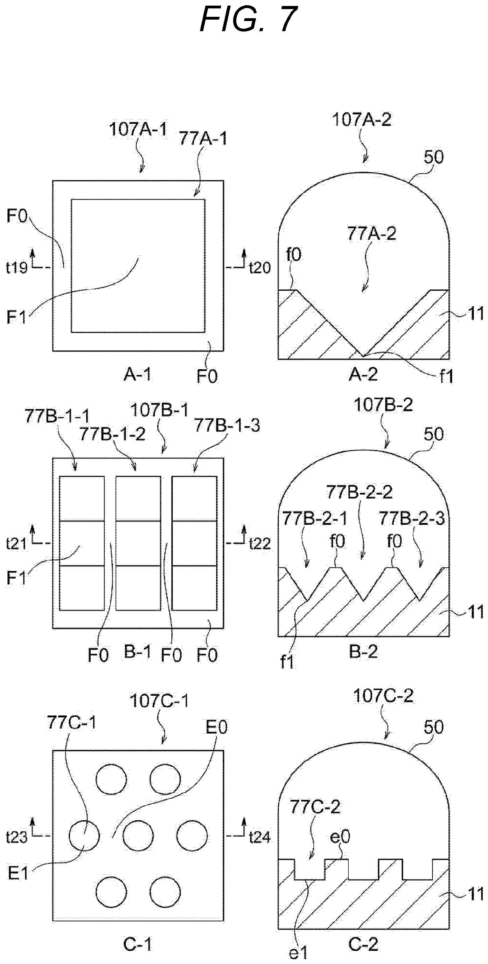

A solid-state imaging device of a fifth embodiment (example 5 of solid-state imaging device) according to the present technology will be described with reference to Fig. 7.

Fig. 7 is a view depicting a configuration example of solid-state imaging devices (solid-state imaging devices 107A, 107B, and 107C) according to the fifth embodiment of the present technology.

Fig. 7A-1 is a top view (plan layout view (plan view) from the light incident side) depicting a configuration example of one pixel of a solid-state imaging device (solid-state imaging device 107A-1) according to the fifth embodiment of the present technology, and Fig. 7A-2 is a cross-sectional view depicting a configuration example of one pixel of a solid-state imaging device (solid-state imaging device 107A-2) according to the fifth embodiment of the present technology according to a t19-t20 line depicted in Fig. 7A-1.

The solid-state imaging device 107A-2 depicted in Fig. 7A-2 includes a semiconductor substrate 11, a photoelectric conversion unit (not depicted) provided on the semiconductor substrate 11, and a recess 77A-2 formed on a surface on the light incident side (upper side in Fig. 7A-2) of the semiconductor substrate 11.

The recess 77A-2 has an inverted triangular shape as depicted in Fig. 7A-2 (in cross-sectional view). In Fig. 7A-1, since a recess 77A-1 corresponding to the recess 77A-2 has a rectangular shape, the shape of the recess 77A (77A-1 and 77A-2) included in the solid-state imaging device 107A (solid-state imaging devices 107A-1 and 107A-2) is an inverted quadrangular pyramid.

Then, in the solid-state imaging device 107A-2, an on-chip lens 50 is provided above the light incident side of the semiconductor substrate 11.

As depicted in Fig. 7A-2, in the recess 77A-2, the semiconductor substrate 11 is dug in the depth direction (direction opposite to the light incident side), and as described above, the inverted triangular shape is formed in a cross-sectional view. It is to be noted that reference sign f1 corresponds to the vertex of the inverted triangle and is the deepest portion of the recess 77A-2, and reference sign f0 is a region where the semiconductor substrate 11 is not dug.

As depicted in Fig. 7A-1, in a plan view, the recess 77A-1 having a rectangular shape (it is to be noted that, as described above, considering the cross-sectional view, the shape is an inverted quadrangular pyramid) included in the solid-state imaging device 107A-1 is arranged. Reference sign f1 shown in Fig. 7A-2 corresponds to a substantially central portion F1 of the recess 77A-1. Reference sign f0 shown in Fig. 7A-2 corresponds to the inner periphery F0 of the recess 77A-1.

Fig. 7B-1 is a top view (plan layout view (plan view) from the light incident side) depicting a configuration example of one pixel of a solid-state imaging device (solid-state imaging device 107B-1) according to the fifth embodiment of the present technology, and Fig. 7B-2 is a cross-sectional view depicting a configuration example of one pixel of a solid-state imaging device (solid-state imaging device 107B-2) according to the fifth embodiment of the present technology according to a t21-t22 line depicted in Fig. 7B-1.

The solid-state imaging device 107B-2 depicted in Fig. 7B-2 includes a semiconductor substrate 11, a photoelectric conversion unit (not depicted) provided on the semiconductor substrate 11, and a recess 77B-2-1, a recess 77B-2-2, and a recess 77B-2-3 formed on a surface on the light incident side (upper side in Fig. 7B-2) of the semiconductor substrate 11.

Each of the recess 77B-2-1, the recess 77B-2-2, and the recess 77B-2-3 has an inverted triangular shape as depicted in Fig. 7B-2 (cross-sectional view). In Fig. 7B-1, the middle recess among the three recesses constituting a recess 77B-1-1 corresponding to the recess 77B-2-1 has a rectangular shape, the middle recess among the three recesses constituting a recess 77B-1-2 corresponding to the recess 77B-2-2 has a rectangular shape, and the middle recess among the three recesses constituting the recess 77B-1-3 corresponding to the recess 77B-2-3 has a rectangular shape. Therefore, the shape of each of the three recesses 77B (77B-1-1 and 77B-2-1, 77B-1-2 and 77B-2-2, and 77B-1-3 and 77B-2-3) included in the solid-state imaging device 107B (solid-state imaging devices 107B-1 and 107B-2) is an inverted quadrangular pyramid shape.

Then, in the solid-state imaging device 107B-2, an on-chip lens 50 is provided above the light incident side of the semiconductor substrate 11.

As depicted in Fig. 7B-2, in each of the recess 77B-2-1, the recess 77B-2-2, and the recess 77B-2-3, the semiconductor substrate 11 is dug in the depth direction (direction opposite to the light incident side), and as described above, the inverted triangular shape is formed in a cross-sectional view. It is to be noted that reference sign f1 corresponds to the vertex of the inverted triangle and is the deepest portion of each of the recess 77B-2-1, the recess 77B-2-2, and the recess 77B-2-3, and reference sign f0 is a region where the semiconductor substrate 11 is not dug.

As depicted in Fig. 7B-1, in a plan view, a recess group 77B-1-1 constituted by three rectangular (it is to be noted that, as described above, considering the cross-sectional view, the shape is an inverted quadrangular pyramid) recesses in the first column (from the left side in the figure), the 77B-1-2 constituted by three rectangular (it is to be noted that, as described above, considering the cross-sectional view, the shape is an inverted quadrangular pyramid) recesses in the second column (from the left side in the figure), and the 77B-1-3 constituted by three rectangular (it is to be noted that, as described above, considering the cross-sectional view, the shape is an inverted quadrangular pyramid) recesses in the third column (from the left side in the figure), which are included in the solid-state imaging device 107B-1, are arranged. Reference sign f1 shown in Fig. 7B-2 corresponds to a substantially central portion F1 of the recess at the center of the recess group 77B-1-1. Reference sign f0 shown in Fig. 7B-2 corresponds to a region F0 where the recess group 77B-1-1, the recess group 77B-1-2, and the recess group 77B-1-3 are not formed.

Fig. 7C-1 is a top view (plan layout view (plan view) from the light incident side) depicting a configuration example of one pixel of a solid-state imaging device (solid-state imaging device 107C-1) according to the fifth embodiment of the present technology, and Fig. 7C-2 is a cross-sectional view depicting a configuration example of one pixel of a solid-state imaging device (solid-state imaging device 107C-2) according to the fifth embodiment of the present technology according to a t23-t24 line depicted in Fig. 7C-1.

The solid-state imaging device 107C-2 depicted in Fig. 7C-2 includes a semiconductor substrate 11, a photoelectric conversion unit (not depicted) provided on the semiconductor substrate 11, and a recess 77C-2 of one step formed on a surface on the light incident side (upper side in Fig. 7A-2) of the semiconductor substrate 11.

The recess 77C-2 has a rectangular shape as depicted in Fig. 7C-2 (in cross-sectional view). In Fig. 7C-1, since a recess 77C-1 corresponding to the recess 77C-2 has a circular shape, the shape of the recess 77C (77C-1 and 77C-2) included in the solid-state imaging device 107C (solid-state imaging devices 107C-1 and 107C-2) is a cylindrical shape.

In Fig. 7C-2, in addition to the recess 77C-2, two recesses having the same surface area (bottom area and side surface area (step depth (height))) as the surface area (bottom area and side surface area (step depth height))) of the recess 77C-2 are formed at the right position of the recess 77C-2.

Then, in the solid-state imaging device 107C-2, an on-chip lens 50 is provided above the light incident side of the semiconductor substrate 11.

As depicted in Fig. 7C-2, in the recess 77C-2, the semiconductor substrate 11 is dug in the depth direction (direction opposite to the light incident side) to form a first step e1. It is to be noted that reference sign e0 is a zeroth step in which the semiconductor substrate 11 is not dug.

As depicted in Fig. 7C-1, in a plan view, a plurality of (seven in one pixel in Fig. 7C-1) the circular recesses 77C-1 of one step included in the solid-state imaging device 107C-1 is arranged, and in Fig. 7C-1, two recesses are arranged in the first row (horizontal direction in the drawing), two recesses are arranged in the second row, and two recesses are arranged in the third row. The arrangement interval (periodicity) of the plurality of recesses 77C-1 may be any interval, but the flare is less likely to occur as the arrangement interval (periodicity) of the plurality of recesses 77C-1 is smaller. The first step e1 depicted in Fig. 7C-2 corresponds to a first step E1. It is to be noted that a zeroth step e0 depicted in Fig. 7C-2 corresponds to a zeroth step E0.

As described above, the content described for the solid-state imaging device of the fifth embodiment (example 5 of solid-state imaging device) according to the present technology can be applied to the above-described solid-state imaging devices of the first to fourth embodiments according to the present technology and the solid-state imaging devices of the sixth to ninth embodiments according to the present technology as described later as long as there is no particular technical contradiction.

<7. Sixth embodiment (Example 6 of Solid-State Imaging Device)>

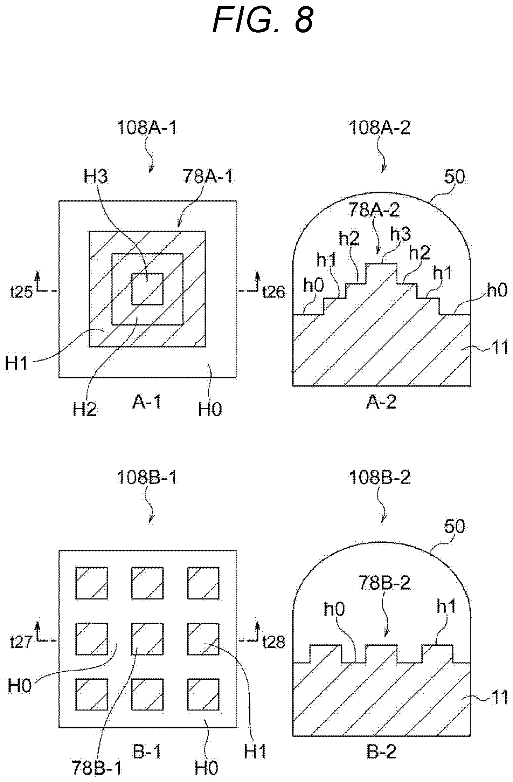

A solid-state imaging device of a sixth embodiment (example 6 of solid-state imaging device) according to the present technology will be described with reference to Fig. 8.

Fig. 8 is a view depicting a configuration example of solid-state imaging devices (solid-state imaging devices 108A and 108B) according to the sixth embodiment of the present technology.

Fig. 8A-1 is a top view (plan layout view (plan view) from the light incident side) depicting a configuration example of one pixel of a solid-state imaging device (solid-state imaging device 108A-1) according to the sixth embodiment of the present technology, and Fig. 8A-2 is a cross-sectional view depicting a configuration example of one pixel of a solid-state imaging device (solid-state imaging device 108A-2) according to the sixth embodiment of the present technology according to a t25-t26 line depicted in Fig. 8A-1.

The solid-state imaging device 108A-2 depicted in Fig. 8A-2 includes a semiconductor substrate 11, a photoelectric conversion unit (not depicted) provided on the semiconductor substrate 11, and a protrusion 78A-2 of two or more steps (three steps in Fig. 8A-2) formed on a surface on the light incident side (upper side in Fig. 8A-2) of the semiconductor substrate 11.

Then, in the solid-state imaging device 108A-2, an on-chip lens 50 is provided above the light incident side of the semiconductor substrate 11.

As depicted in Fig. 8A-2, in the protrusion 78A-2, semiconductor substrates are stacked from the surface on the light incident side of the semiconductor substrate 11 toward the direction (upward) on the light incident side to form a first step h1, a second step h2, and a third step h3. It is to be noted that reference sign h0 is a zeroth step of the semiconductor substrate 11 on which the semiconductor substrates are not stacked.

As depicted in Fig. 8A-1, in a plan view, a protrusion 78A-1 included in the solid-state imaging device 108A-1 has a rectangular shape. Specifically, a first step H1 corresponding to the first step h1 and a second step H2 corresponding to the second step h2 depicted in Fig. 8A-2 are formed in a rectangular shape with a predetermined width along the inner periphery of the pixel, and a third step H3 corresponding to the third step h3 is rectangular. It is to be noted that a zeroth step h0 corresponds to a zeroth step H0.

Fig. 8B-1 is a top view (plan layout view (plan view) from the light incident side) depicting a configuration example of one pixel of a solid-state imaging device (solid-state imaging device 108B-1) according to the sixth embodiment of the present technology, and Fig. 8B-2 is a cross-sectional view depicting a configuration example of one pixel of a solid-state imaging device (solid-state imaging device 108B-2) according to the sixth embodiment of the present technology according to a t27-t28 line depicted in Fig. 8B-1.

The solid-state imaging device 108B-2 depicted in Fig. 8B-2 includes a semiconductor substrate 11, a photoelectric conversion unit (not depicted) provided on the semiconductor substrate 11, and a protrusion 78B-2 of one step formed on a surface on the light incident side (upper side in Fig. 8B-2) of the semiconductor substrate 11.

In Fig. 8B-2, in addition to the protrusion 78B-2, a protrusion having the same surface area (bottom area and side surface area (step height)) as the surface area (bottom area and side surface area (step height)) of the protrusion 78B-2 is formed at each of the left and right positions of the protrusion 78B-2.

Then, in the solid-state imaging device 108B-2, an on-chip lens 50 is provided above the light incident side of the semiconductor substrate 11.

As depicted in Fig. 8B-2, in the protrusion 78B-2, semiconductor substrates are stacked from the surface on the light incident side of the semiconductor substrate 11 toward the direction (upward) on the light incident side to form a first step h1. It is to be noted that reference sign h0 is a zeroth step of the semiconductor substrate 11 on which the semiconductor substrates are not stacked.

As depicted in Fig. 8B-1, in a plan view, a plurality of (nine in one pixel in Fig. 8B-1) rectangular protrusions 78B-1 of one step included in the solid-state imaging device 108B-1 is arranged, and in Fig. 8B-1, three protrusions are arranged in the first row (horizontal direction in the drawing), three protrusions are arranged in the second row, and three protrusions are arranged in the third row. The arrangement interval (periodicity) of the plurality of protrusions 78B-1 may be any interval, but the flare is less likely to occur as the arrangement interval (periodicity) of the plurality of protrusions 78B-1 is smaller. The first step h1 depicted in Fig. 8B-2 corresponds to a first step H1. It is to be noted that a zeroth step h0 depicted in Fig. 8B-2 corresponds to a zeroth step H0.

As described above, the content described for the solid-state imaging device of the sixth embodiment (example 6 of solid-state imaging device) according to the present technology can be applied to the above-described solid-state imaging devices of the first to fifth embodiments according to the present technology and the solid-state imaging devices of the seventh to ninth embodiments according to the present technology as described later as long as there is no particular technical contradiction.

<8. Seventh Embodiment (Example 7 of Solid-State Imaging Device)>

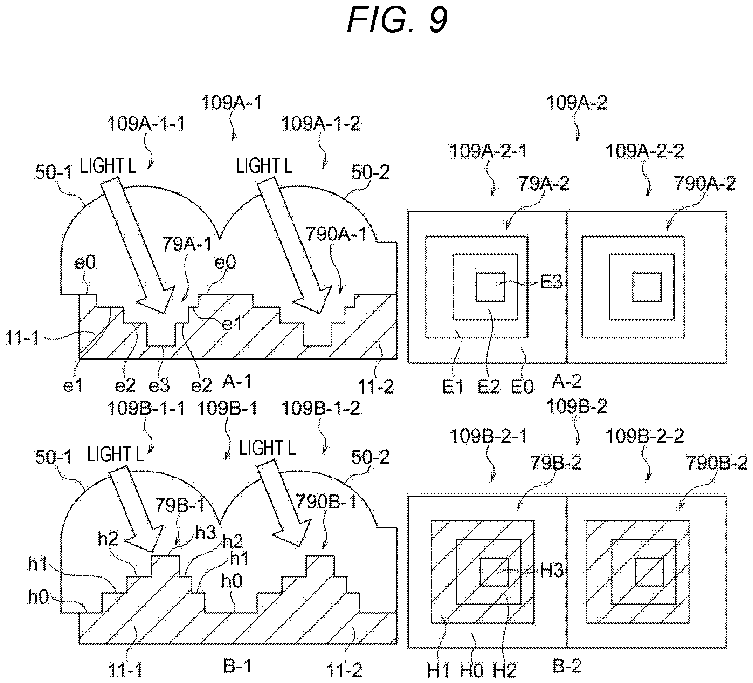

A solid-state imaging device of a seventh embodiment (example 7 of solid-state imaging device) according to the present technology will be described with reference to Fig. 9

Fig. 9 is a view depicting a configuration example of solid-state imaging devices (solid-state imaging devices 109A and 109B) according to the seventh embodiment of the present technology.

More specifically, Fig. 9A-1 is a cross-sectional view depicting a configuration example for two pixels of a solid-state imaging device (solid-state imaging device 109A-1) according to the seventh embodiment of the present technology, and Fig. 9A-2 is a top view (plan layout view (plan view) from the light incident side) depicting a configuration example for two pixels of a solid-state imaging device (solid-state imaging device 109A-2) according to the seventh embodiment of the present technology.

The solid-state imaging device 109A-1 depicted in Fig. 9A-1 includes two pixels of a pixel 109A-1-1 and a pixel 109A-1-2. The pixel 109A-1-1 includes a semiconductor substrate 11-1, a photoelectric conversion unit (not depicted) provided on the semiconductor substrate 11-1, and a recess 79A-1 of two or more steps (three steps in Fig. 9A-1) formed on a surface on the light incident side (upper side in Fig. 9A-1) of the semiconductor substrate 11-1. On the other hand, the pixel 109A-1-2 includes a semiconductor substrate 11-2, a photoelectric conversion unit (not depicted) provided on the semiconductor substrate 11-2, and a recess 790A-1 of two or more steps (three steps in Fig. 9A-1) formed on a surface on the light incident side (upper side in Fig. 9A-1) of the semiconductor substrate 11-2.

Then, in the pixel 109A-1-1 of the solid-state imaging device 109A-1, an on-chip lens 50-1 is provided above the light incident side of the semiconductor substrate 11-1, and in the pixel 109A-1-2, an on-chip lens 50-2 is provided above the light incident side of the semiconductor substrate 11-2. To collect oblique light L from the upper left direction to the lower right direction, the on-chip lenses 50-1 and 50-2 are arranged in the left direction with respect to the semiconductor substrates 11-1 and 11-2 (pupil correction).

As depicted in Fig. 9A-1, in the recess 79A-1, the semiconductor substrate 11-1 is dug in the depth direction (direction opposite to the light incident side) to form a first step e1, a second step e2, and a third step e3. It is to be noted that reference sign e0 is a zeroth step in which the semiconductor substrate 11-1 is not dug. The recess 790A-1 has a similar configuration.

As depicted in Fig. 9A-2, in a plan view, a recess 79A-2 included in the solid-state imaging device 109A-2 (pixel 109A-2-1) has a rectangular shape. Specifically, a first step E1 corresponding to the first step e1 and a second step E2 corresponding to the second step e2 depicted in Fig. 9A-1 are formed in a rectangular shape with a predetermined width along the inner periphery of the pixel 109A-2-1, and a third step E3 corresponding to the third step e3 is rectangular. It is to be noted that a zeroth step e0 corresponds to a zeroth step E0. A recess 790A-2 included in the solid-state imaging device 109A-2 (pixel 109A-2-2) has a similar configuration.

The position of the center of the recess 79A-2 is on the left side with respect to the position of the center of the pixel 109A-2-1, and similarly, the position of the center of the recess 790A-2 is on the left side with respect to the position of the center of the pixel 109A-2-2 (pupil correction). That is, the left width (surface area) of the first step E1 (first step e1) is larger than the right width (surface area) of the first step E1 (first step e1), and the left width (surface area) of the second step E2 (second step e2) is larger than the right width (surface area) of the second step E2 (second step e2).

Fig. 9B-1 is a cross-sectional view depicting a configuration example for two pixels of a solid-state imaging device (solid-state imaging device 109B-1) according to the seventh embodiment of the present technology, and Fig. 9B-2 is a top view (plan layout view (plan view) from the light incident side) depicting a configuration example for two pixels of a solid-state imaging device (solid-state imaging device 109B-2) according to the seventh embodiment of the present technology.

The solid-state imaging device 109B-1 depicted in Fig. 9B-1 includes two pixels of a pixel 109B-1-1 and a pixel 109B-1-2. The pixel 109B-1-1 includes a semiconductor substrate 11-1, a photoelectric conversion unit (not depicted) provided on the semiconductor substrate 11-1, and a protrusion 79B-1 of two or more steps (three steps in Fig. 9B-1) formed on a surface on the light incident side (upper side in Fig. 9B-1) of the semiconductor substrate 11-1. On the other hand, the pixel 109B-1-2 includes a semiconductor substrate 11-2, a photoelectric conversion unit (not depicted) provided on the semiconductor substrate 11-2, and a protrusion 790B-1 of two or more steps (three steps in Fig. 9B-1) formed on a surface on the light incident side (upper side in Fig. 9B-1) of the semiconductor substrate 11-2.

Then, in the pixel 109B-1-1 of the solid-state imaging device 109B-1, an on-chip lens 50-1 is provided above the light incident side of the semiconductor substrate 11-1, and in the pixel 109B-1-2, an on-chip lens 50-2 is provided above the light incident side of the semiconductor substrate 11-2. To collect oblique light L from the upper left direction to the lower right direction, the on-chip lenses 50-1 and 50-2 are arranged in the left direction with respect to the semiconductor substrates 19-B-1 and 19-B-2 (pupil correction).

As depicted in Fig. 9B-1, in the protrusion 79B-1, semiconductor substrates are stacked from the surface on the light incident side of the semiconductor substrate 11-2 toward the direction (upward) on the light incident side to form a first step h1, a second step h2, and a third step h3. It is to be noted that reference sign h0 is a zeroth step of the semiconductor substrate 11-2 on which the semiconductor substrates are not stacked. The protrusion 790B-1 has a similar configuration.

As depicted in Fig. 9B-2, in a plan view, a protrusion 79B-2 included in the solid-state imaging device 109B-2 (pixel 109B-2-1) has a rectangular shape. Specifically, a first step H1 corresponding to the first step h1 and a second step H2 corresponding to the second step h2 depicted in Fig. 9B-1 are formed in a rectangular shape with a predetermined width along the inner periphery of the pixel 109B-2-1, and a third step H3 corresponding to the third step h3 is rectangular. It is to be noted that a zeroth step h0 corresponds to a zeroth step H0. A protrusion 790B-2 included in the solid-state imaging device 109B-2 (pixel 109B-2-2) has a similar configuration.

The position of the center of the protrusion 79B-2 is on the left side with respect to the position of the center of the pixel 109B-2-1, and similarly, the position of the center of the protrusion 790B-2 is on the left side with respect to the position of the center of the pixel 109B-2-2 (pupil correction). That is, the left width (surface area) of the first step H1 (first step h1) is larger than the right width (surface area) of the first step H1 (first step h1), and the left width (surface area) of the second step H2 (second step h2) is larger than the right width (surface area) of the second step H2 (second step h2).

As described above, the content described for the solid-state imaging device of the seventh embodiment (example 7 of solid-state imaging device) according to the present technology can be applied to the above-described solid-state imaging devices of the first to sixth embodiments according to the present technology and the solid-state imaging devices of the eighth to ninth embodiments according to the present technology as described later as long as there is no particular technical contradiction.

<9. Eighth Embodiment (Example 8 of Solid-State Imaging Device)>

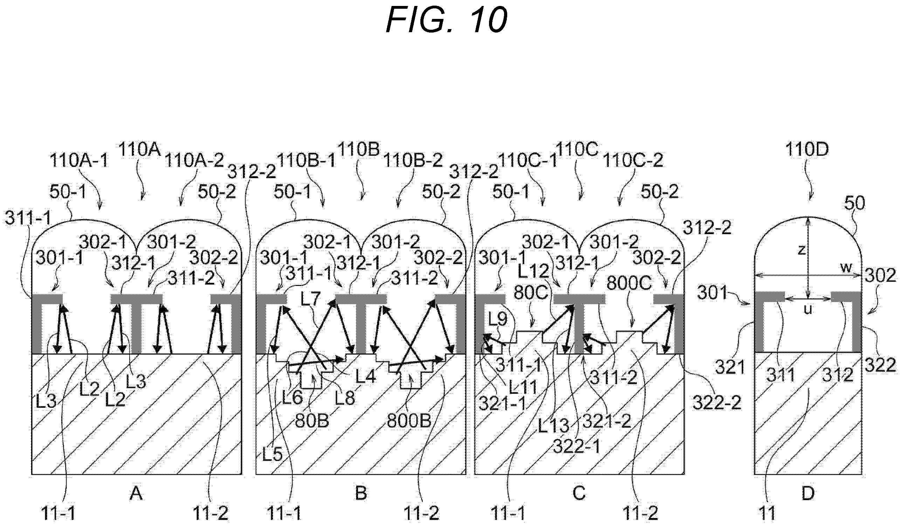

A solid-state imaging device of an eighth embodiment (example 8 of solid-state imaging device) according to the present technology will be described with reference to Fig. 10.

Fig. 10 is a view depicting a configuration example of solid-state imaging devices (solid-state imaging devices 110A, 110B, 110C, and 110D) according to the eighth embodiment of the present technology.

More specifically, Fig. 10A is a cross-sectional view depicting a configuration example for two pixels of the solid-state imaging device (solid-state imaging device 110A) according to the eighth embodiment of the present technology, Fig. 10B is a cross-sectional view depicting a configuration example for two pixels of the solid-state imaging device (solid-state imaging device 110B) according to the eighth embodiment of the present technology, Fig. 10C is a cross-sectional view depicting a configuration example for two pixels of the solid-state imaging device (solid-state imaging device 110C) according to the eighth embodiment of the present technology, and Fig. 10D is a cross-sectional view depicting a configuration example for one pixel of the solid-state imaging device (solid-state imaging device 110D) according to the eighth embodiment of the present technology.

The solid-state imaging device 110A depicted in Fig. 10A includes two pixels of a pixel 110A-1 and a pixel 110A-2. The pixel 110A-1 includes a semiconductor substrate 11-1 and a photoelectric conversion unit (not depicted) provided on the semiconductor substrate 11-1. On the other hand, the pixel 110A-2 includes a semiconductor substrate 11-2 and a photoelectric conversion unit (not depicted) provided on the semiconductor substrate 11-2.

Then, in the pixel 110A-1 of the solid-state imaging device 110A, two light-shielding walls 301-1 (inverted L-shape) and 302-1 (inverted L-shape) are provided above the light incident side of the semiconductor substrate 11-1. Then, an on-chip lens 50-1 is provided above the light incident side of the two light-shielding walls 301-1 and 302-1. In the pixel 110A-2, two light-shielding walls 301-2 (inverted L-shape) and 302-2 (inverted L-shape) are provided above the light incident side of the semiconductor substrate 11-2. Then, an on-chip lens 50-2 is provided above the light incident side of the two light-shielding walls 301-2 and 302-2. It is to be noted that a T-shaped light-shielding wall is formed between the pixels (between the pixel 110A-1 and the pixel 110A-2) by the light-shielding wall 302-1 (inverted L-shape) and the light-shielding wall 301-2 (inverted L-shape) (the same applies hereinafter).

As depicted in Fig. 10A, light L2 reflected by the surface on the light incident side of the semiconductor substrate 11-1 is reflected by a first portion 311-1 constituting the light-shielding wall 301-1 and a first portion 312-1 constituting the light-shielding wall 302-1, and is absorbed (photoelectrically converted) by the semiconductor substrate 11-1 as light L3.

The solid-state imaging device 110B depicted in Fig. 10B includes two pixels of a pixel 110B-1 and a pixel 110B-2. The pixel 110B-1 includes a semiconductor substrate 11-1, a photoelectric conversion unit (not depicted) provided on the semiconductor substrate 11-1, and a recess 80B of two or more steps (three steps in Fig. 10B) formed on a surface on the light incident side (upper side in Fig. 10B) of the semiconductor substrate 11-1. On the other hand, the pixel 110B-2 includes a semiconductor substrate 11-2, a photoelectric conversion unit (not depicted) provided on the semiconductor substrate 11-2, and a recess 800B of two or more steps (three steps in Fig. 10B) formed on a surface on the light incident side (upper side in Fig. 10B) of the semiconductor substrate 11-2.

Then, in the pixel 110B-1 of the solid-state imaging device 110B, two light-shielding walls 301-1 (inverted L-shape) and 302-1 (inverted L-shape) are provided above the light incident side of the semiconductor substrate 11-1. Then, an on-chip lens 50-1 is provided above the light incident side of the two light-shielding walls 301-1 and 302-1. In the pixel 110B-2, two light-shielding walls 301-2 and 302-2 are provided above the light incident side of the semiconductor substrate 11-2. Then, an on-chip lens 50-2 is provided above the light incident side of the two light-shielding walls 301-2 and 302-2.

As depicted in Fig. 10B, light L4 reflected by the second step on the right side of the recess 80B of the semiconductor substrate 11-1 is reflected by a first portion 311-1 constituting the light-shielding wall 301-1 and absorbed (photoelectrically converted) by the semiconductor substrate 11-1 as light L5. Further, light L6 reflected by the second step on the left side of the recess 80B of the semiconductor substrate 11-1 is reflected by a first portion 312-1 constituting the light-shielding wall 302-1 and absorbed (photoelectrically converted) by the semiconductor substrate 11-1 as light L7. Light L8 is reflected in the recess 80B a plurality of times, and is eventually absorbed (photoelectrically converted) by the semiconductor substrate 11-1, although not depicted.

The solid-state imaging device 110C depicted in Fig. 10C includes two pixels of a pixel 110C-1 and a pixel 110C-2. The pixel 110C-1 includes a semiconductor substrate 11-1, a photoelectric conversion unit (not depicted) provided on the semiconductor substrate 11-1, and a protrusion 80C of two or more steps (three steps in Fig. 10C) formed on a surface on the light incident side (upper side in Fig. 10C) of the semiconductor substrate 11-1. On the other hand, the pixel 110C-2 includes a semiconductor substrate 11-2, a photoelectric conversion unit (not depicted) provided on the semiconductor substrate 11-2, and a protrusion 800C of two or more steps (three steps in Fig. 10B) formed on a surface on the light incident side (upper side in Fig. 10C) of the semiconductor substrate 11-2.

Then, in the pixel 110C-1 of the solid-state imaging device 110C, two light-shielding walls 301-1 (inverted L-shape) and 302-1 (inverted L-shape) are provided above the light incident side of the semiconductor substrate 11-1. Then, an on-chip lens 50-1 is provided above the light incident side of the two light-shielding walls 301-1 and 302-1. In the pixel 110C-2, two light-shielding walls 301-2 and 302-2 are provided above the light incident side of the semiconductor substrate 11-2. Then, an on-chip lens 50-2 is provided above the light incident side of the two light-shielding walls 301-2 and 302-2.

As depicted in Fig. 10C, light L9 reflected by the first step on the left side of the protrusion 80C of the semiconductor substrate 11-1 is reflected by a second portion 321-1 constituting the light-shielding wall 301-1 and absorbed (photoelectrically converted) by the semiconductor substrate 11-1 as light L11. Further, light L12 reflected by the second step on the right side of the protrusion 80C of the semiconductor substrate 11-1 is reflected by a first portion 312-1 and a second portion 322-1 constituting the light-shielding wall 302-1 and absorbed (photoelectrically converted) by the semiconductor substrate 11-1 as light L13.

The solid-state imaging device 110D depicted in Fig. 10D includes a semiconductor substrate 11 and a photoelectric conversion unit (not depicted) provided on the semiconductor substrate 11.

Then, in the solid-state imaging device 110D, two light-shielding walls 301 and 302 are provided above the light incident side of the semiconductor substrate 11. Then, an on-chip lens 50 is provided above the light incident side of the two light-shielding walls 301 and 302.

In the solid-state imaging device 110D, the width of the opening formed by the two light-shielding walls 301 and 302 (two first portions 311 and 312) satisfies the following Expression (4).

$$1.22 * \lambda/n < u < W * (f-z)/f \quad \cdots (4)$$

In Expression (4), $\lambda$ is the wavelength of incident light, n is the n value of the on-chip lens 50, W is the size (width) of the on-chip lens 50, f is the F value of the on-chip lens 50, z is the distance from the uppermost portion on the light incident side of the on-chip lens to the opening, and u is the width of the opening.

By disposing the two light-shielding walls 301 and 302, light reflected on the surface of the semiconductor substrate 11 can be confined, and color mixing and flare can be further prevented. It is to be noted that, in a case where the protrusions 80C and 800C are formed, it is preferable that the two light-shielding walls 301 and 302 are disposed to prevent color mixing in the reflection direction.

As described above, the content described for the solid-state imaging device of the eighth embodiment (example 8 of solid-state imaging device) according to the present technology can be applied to the above-described solid-state imaging device of the first to seventh embodiments according to the present technology and the solid-state imaging devices of the ninth embodiment according to the present technology as described later as long as there is no particular technical contradiction.

<10. Ninth Embodiment (Example 9 of Solid-State Imaging Device)>

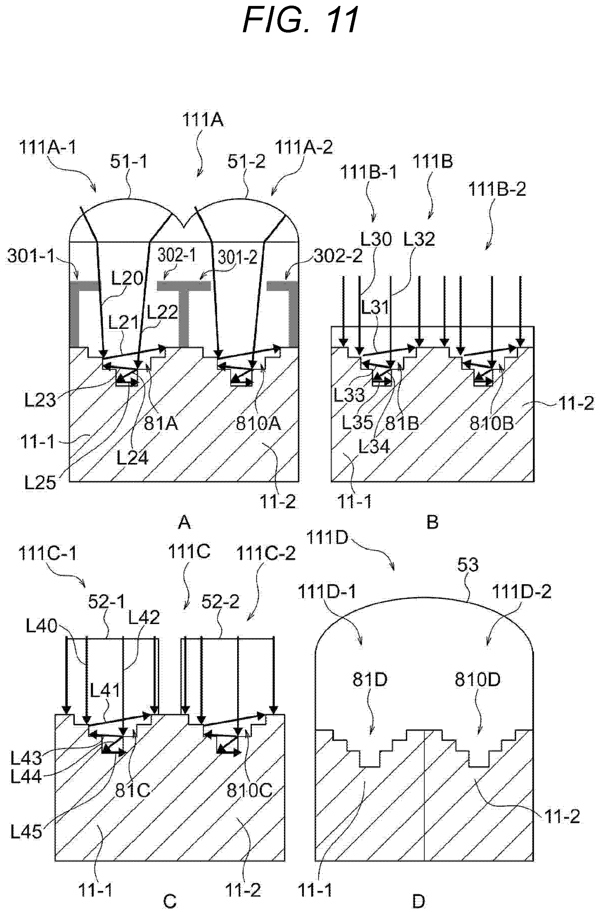

A solid-state imaging device of a ninth embodiment (example 9 of solid-state imaging device) according to the present technology will be described with reference to Fig. 11.

Fig. 11 is a cross-sectional view depicting a configuration example of a solid-state imaging device of the ninth embodiment according to the present technology.

More specifically, Fig. 11A is a cross-sectional view depicting a configuration example for two pixels of a solid-state imaging device (solid-state imaging device 111A) according to the ninth embodiment of the present technology, Fig. 11B is a cross-sectional view depicting a configuration example for two pixels of a solid-state imaging device (solid-state imaging device 111B) according to the ninth embodiment of the present technology, Fig. 11C is a cross-sectional view depicting a configuration example for two pixels of a solid-state imaging device (solid-state imaging device 111C) according to the ninth embodiment of the present technology, and Fig. 11D is a cross-sectional view depicting a configuration example for two pixels of a solid-state imaging device (solid-state imaging device 111D) according to the ninth embodiment of the present technology.

The solid-state imaging device 111A depicted in Fig. 11A includes two pixels of a pixel 111A-1 and a pixel 111A-2. The pixel 111A-1 includes a semiconductor substrate 11-1, a photoelectric conversion unit (not depicted) provided on the semiconductor substrate 11-1, and a recess 81A of two or more steps (three steps in Fig. 11A) formed on a surface on the light incident side (upper side in Fig. 11A) of the semiconductor substrate 11-1. On the other hand, the pixel 111A-2 includes a semiconductor substrate 11-2, a photoelectric conversion unit (not depicted) provided on the semiconductor substrate 11-2, and a recess 810A of two or more steps (three steps in Fig. 11A) formed on a surface on the light incident side (upper side in Fig. 11A) of the semiconductor substrate 11-2.

Then, in the pixel 111A-1 of the solid-state imaging device 111A, an on-chip lens 51-1 (on-chip lens having an upwardly convex curved surface shape) is provided above the light incident side of the semiconductor substrate 11-1, and in the pixel 111A-2, an on-chip lens 51-2 (on-chip lens having an upwardly convex curved surface shape) is provided above the light incident side of the semiconductor substrate 11-2.

A material constituting the on-chip lenses 51-1 and 51-2 may be different from a material constituting an insulating layer disposed between the semiconductor substrate 21A and the on-chip lenses 51-1 and 51-2. For example, for the on-chip lenses 51-1 and 51-2 (in particular, the upwardly convex curved surface shape portions of the on-chip lenses 51-1 and 51-2), an organic material used for an insulating film or the like, or a material having a refractive index higher than the refractive index of $SiO_2$ or SiN may be used to increase the light condensing property of the incident light.

As depicted in Fig. 11A, by increasing the light condensing property of the on-chip lenses 51-1 and 51-2, incident light L20 and L22 can pass through the opening formed by light-shielding walls 301-1 and 302-1 (301-2 and 302-2) disposed above the light incident side of the semiconductor substrate 21A. The incident light L20 (for example, light in the UV region) is reflected near the first step on the left side of the recess 81A to become reflected light L22 and is absorbed (photoelectrically converted) by the semiconductor substrate 11-1. The incident light L22 (for example, light in the UV region) is reflected by the second step on the right side of the recess 81A to become reflected light L23 and reflected light L24, and thereafter, the reflected light L23 is absorbed (photoelectrically converted) by the semiconductor substrate 11-1. The reflected light L24 is further reflected between the second and third steps on the left side of the recess 81A to become reflected light L25, and is absorbed (photoelectrically converted) by the semiconductor substrate 21A.

The solid-state imaging device 111B depicted in Fig. 11B includes two pixels of a pixel 111B-1 and a pixel 111B-2. The pixel 111B-1 includes a semiconductor substrate 11-1, a photoelectric conversion unit (not depicted) provided on the semiconductor substrate 11-1, and a recess 81B of two or more steps (three steps in Fig. 11B) formed on a surface on the light incident side (upper side in Fig. 11B) of the semiconductor substrate 11-1. On the other hand, the pixel 111B-2 includes a semiconductor substrate 11-2, a photoelectric conversion unit (not depicted) provided on the semiconductor substrate 11-2, and a recess 810B of two or more steps (three steps in Fig. 11B) formed on a surface on the light incident side (upper side in Fig. 11B) of the semiconductor substrate 11-2.

It is to be noted that, since the solid-state imaging device 111B does not have an on-chip lens (OCL-less), incident light L30 (for example, light in the UV region) and incident light L32 (for example, light in the UV region) are not condensed. The incident light L30 (for example, light in the UV region) is not refracted, and is reflected near the first step on the left side of the recess 81B to become reflected light L31 and is absorbed (photoelectrically converted) by the semiconductor substrate 11-1. The incident light L32 (for example, light in the UV region) is also not refracted, and is reflected by the second step on the right side of the recess 81B to become reflected light L33 and reflected light L34, and thereafter, the reflected light L33 is absorbed (photoelectrically converted) by the semiconductor substrate 11-1. The reflected light L34 is further reflected between the second and third steps on the left side of the recess 81B to become reflected light L35, and is absorbed (photoelectrically converted) by the semiconductor substrate 21B.

The solid-state imaging device 111C depicted in Fig. 11C includes two pixels of a pixel 111C-1 and a pixel 111C-2. The pixel 111C-1 includes a semiconductor substrate 11-1, a photoelectric conversion unit (not depicted) provided on the semiconductor substrate 11-1, and a recess 81C of two or more steps (three steps in Fig. 11C) formed on a surface on the light incident side (upper side in Fig. 11C) of the semiconductor substrate 11-1. On the other hand, the pixel 111C-2 includes a semiconductor substrate 11-2, a photoelectric conversion unit (not depicted) provided on the semiconductor substrate 11-2, and a recess 810C of two or more steps (three steps in Fig. 11C) formed on a surface on the light incident side (upper side in Fig. 11C) of the semiconductor substrate 11-2.

Then, in the pixel 111C-1 of the solid-state imaging device 111C, a box lens (on-chip lens) 52-1 is provided above the light incident side of the semiconductor substrate 21C, and in the pixel 111C-2, a box lens (on-chip lens) 52-2 is provided above the light incident side of the semiconductor substrate 21C.

Since the box lenses (on-chip lenses) 52-1 and 52-2 do not have a curved surface shape like the on-chip lenses 51-1 and 51-2, incident light L40 (for example, light in the UV region) and incident light L42 (for example, light in the UV region) travel substantially straight downward (toward the photoelectric conversion unit (semiconductor substrate 21C)). The L40 (for example, light in the UV region) is reflected near the first step on the left side of the recess 81C to become reflected light L41 and is absorbed (photoelectrically converted) by the semiconductor substrate 11-1. The incident light L42 (for example, light in the UV region) is reflected by the second step on the right side of the recess 81C to become reflected light L43 and reflected light L44, and thereafter, the reflected light L43 is absorbed (photoelectrically converted) by the semiconductor substrate 21C. The reflected light L44 is further reflected between the second and third steps on the left side of the recess 81C to become reflected light L45, and is absorbed (photoelectrically converted) by the semiconductor substrate 11-1.

The solid-state imaging device 111D depicted in Fig. 11D includes two pixels of a pixel 111D-1 and a pixel 111D-2. The pixel 111D-1 includes a semiconductor substrate 11-1, a photoelectric conversion unit (not depicted) provided on the semiconductor substrate 11-1, and a recess 81D of two or more steps (three steps in Fig. 11D) formed on a surface on the light incident side (upper side in Fig. 11D) of the semiconductor substrate 11-1. On the other hand, the pixel 111D-2 includes a semiconductor substrate 11-2, a photoelectric conversion unit (not depicted) provided on the semiconductor substrate 11-2, and a recess 810D of two or more steps (three steps in Fig. 11D) formed on a surface on the light incident side (upper side in Fig. 11D) of the semiconductor substrate 11-2.

Then, in the solid-state imaging device 111D, one on-chip lens 53 is provided above the light incident side of the semiconductor substrate 11-1 (pixel 111D-1) and the semiconductor substrate 11-2 (pixel 111D-2). That is, the on-chip lens 53 is shared by the two pixels (pixel 111D-1 and pixel 111D-2). Further, for example, the on-chip lens 53 may be shared by a total of four pixels by further adding two pixels arranged on the front side or the back side of the paper surface of Fig. 11D to the two pixels (pixel 111D-1 and pixel 111D-2).

As described above, the content described for the solid-state imaging device of the ninth embodiment (example 9 of solid-state imaging device device) according to the present technology can be applied to the solid-state imaging device of the first to eighth embodiments according to the present technology as described later unless there is a particular technical contradiction.

<11. Tenth Embodiment (Example of Electronic Device)>

An electronic device according to a tenth embodiment of the present technology is, as a first aspect, an electronic device on which the solid-state imaging device according to the first aspect of the present technology is mounted, and the solid-state imaging device according to the first aspect of the present technology is a solid-state imaging device including a semiconductor substrate, a photoelectric conversion unit provided on the semiconductor substrate, and a recess of two or more steps formed on a surface on a light incident side of the semiconductor substrate.

Further, an electronic device according to the tenth embodiment of the present technology is, as a second aspect, an electronic device on which the solid-state imaging device according to the second aspect of the present technology is mounted. The solid-state imaging device according to the second aspect of the present technology is a solid-state imaging device including: a semiconductor substrate; a photoelectric conversion unit provided on the semiconductor substrate; and a light-shielding wall provided above a light incident side of the semiconductor substrate, in which the light-shielding wall includes a first portion having a first width extending in a direction substantially parallel to a light incident surface of the semiconductor substrate, and a second portion having a second width extending in a direction substantially perpendicular to the light incident surface, the second width being smaller than the first width, and the second portion is provided between the first portion and the semiconductor substrate.

The electronic device of the tenth embodiment according to the present technology is, for example, an electronic device on which the solid-state imaging device according to any one of the embodiments out of the solid-state imaging devices of the first to ninth embodiments according to the present technology is mounted.

<12. Usage Example of Solid-State Imaging Device to which Present Technology is Applied>

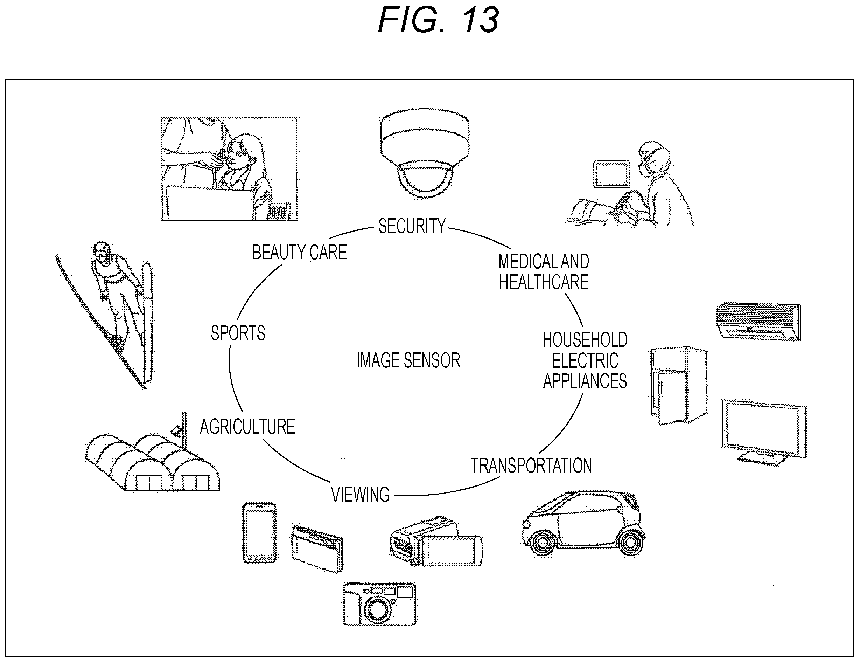

Fig. 13 is a view depicting a usage example, as an image sensor, of the solid-state imaging device of the first to ninth embodiments according to the present technology.

The solid-state imaging device of the first to ninth embodiments described above can be used in various cases for sensing light such as visible light, infrared light, ultraviolet light, X-ray, and the like, as described below, for example.

That is, as depicted in Fig. 13, for example, the solid-state imaging device of any one of the first to ninth embodiments may be used in a device (for example, the electronic device of the tenth embodiment described above) used in a field of viewing in which an image to be viewed is taken, a field of transportation, a field of household electric appliances, a field of medical and healthcare, a field of security, a field of beauty care field, a field of sports, a field of agriculture, and the like.

Specifically, in the field of viewing, the solid-state imaging device of any one of the first to ninth embodiments can be used for devices to capture an image to be used for viewing, for example, such as a digital camera, a smartphone, or a mobile phone with a camera function.

In the field of transportation, for example, for safe driving such as automatic stop, recognition of a state of a driver, and the like, the solid-state imaging device of any one of the first to ninth embodiments can be used for devices used for transportation, such as vehicle-mounted sensors that capture an image in front, rear, surroundings, interior, and the like of an automobile, monitoring cameras that monitor traveling vehicles and roads, and distance measurement sensors that measure a distance between vehicles.

In the field of household electric appliances, for example, to capture an image of a user's gesture and operate a device in accordance with the gesture, the solid-state imaging device of any one of the first to ninth embodiments can be used for devices used in household electric appliances such as TV receivers, refrigerators, air conditioners, and the like.

In the field of medical and healthcare, for example, the solid-state imaging device of any one of the first to ninth embodiments can be used for devices used for medical and healthcare, such as endoscopes and devices that perform angiography by receiving infrared light.

In the field of security, for example, the solid-state imaging device of any one of the first to ninth embodiments can be used for devices used for security such as monitoring cameras for crime suppression and cameras for personal authentication.

In the field of beauty care, for example, the solid-state imaging device of any one of the first to ninth embodiments can be used for devices used for beauty care such as skin measuring instruments for image capturing of skin, and microscopes for image capturing of a scalp.

In the field of sports, for example, the solid-state imaging device of any one of the first to ninth embodiments can be used for devices used for sports such as action cameras and wearable cameras for sports applications.

In the field of agriculture, for example, the solid-state imaging device of any one of the first to ninth embodiments can be used for devices used for agriculture such as cameras for monitoring conditions of fields and crops.

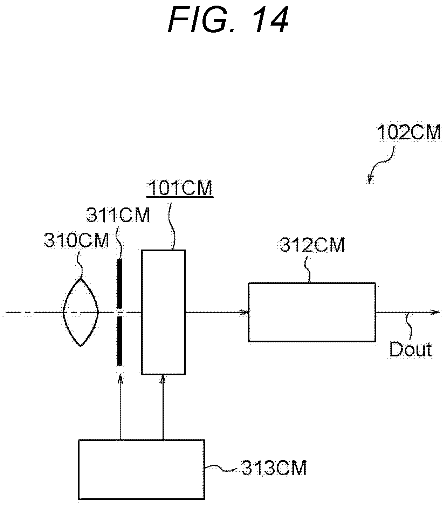

Next, a usage example of the solid-state imaging device of the first to ninth embodiments according to the present technology will be specifically described. For example, the solid-state imaging device of any one of the first to ninth embodiments described above can be applied to any type of electronic devices having an imaging function such as a camera system such as a digital still camera or a video camera, or a mobile phone having an imaging function, for example, as a solid-state imaging device 101CM. Fig. 14 depicts a schematic configuration of an electronic device (camera) 102CM as an example. The electronic device 102CM is, for example, a video camera capable of capturing a still image or a moving image, and includes the solid-state imaging device 101CM, an optical system (optical lens) 310CM, a shutter device 311CM, a driving unit 313CM that drives the solid-state imaging device 101CM and the shutter device 311CM, and a signal processing unit 312CM.

The optical system 310CM guides image light (incident light) from a subject to a pixel unit included in the solid-state imaging device 101CM. The optical system 310CM may include a plurality of optical lenses. The shutter device 311CM controls a light irradiation period and a light shielding period for the solid-state imaging device 101CM. The driving unit 313CM controls a transfer operation of the solid-state imaging device 101CM and a shutter operation of the shutter device 311CM. The signal processing unit 312CM performs various types of signal processing on a signal output from the solid-state imaging device 101CM. A video signal Dout after the signal processing is stored in a storage medium such as a memory or output to a monitor and the like.

<13. Application Example to Endoscopic Surgery System>

The present technology can be applied to various products. For example, the technology according to the present disclosure (present technology) may be applied to an endoscopic surgery system.

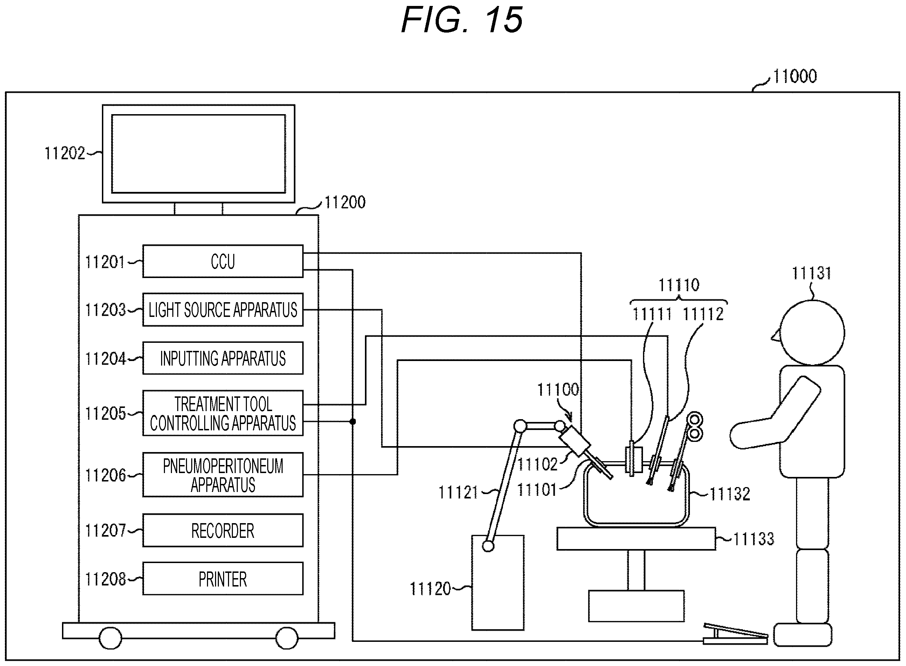

Fig. 15 is a view depicting an example of a schematic configuration of an endoscopic surgery system to which the technology according to an embodiment of the present disclosure (present technology) can be applied.

In Fig. 15, a state is depicted in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy treatment device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy treatment device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

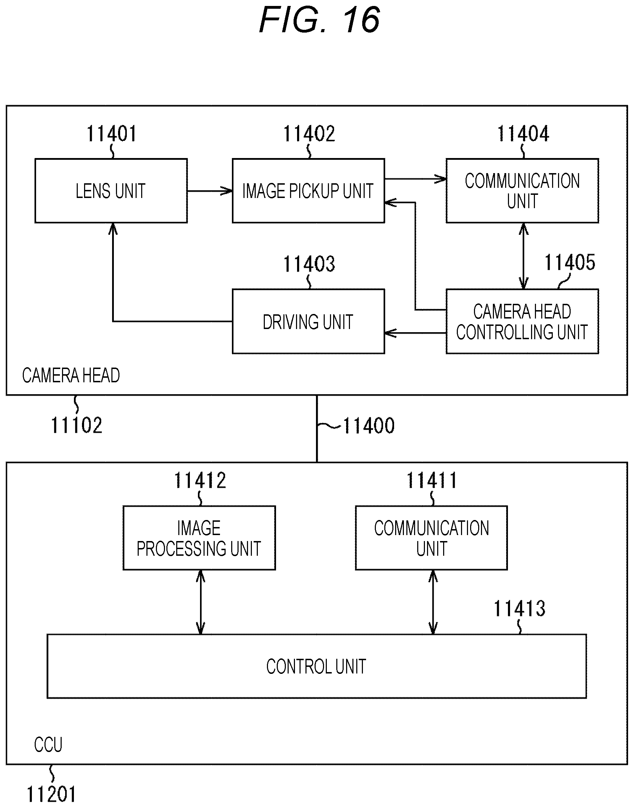

Fig. 16 is a block diagram depicting an example of a functional configuration of the camera head 11102 and the CCU 11201 depicted in Fig. 15.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The image pickup unit 11402 includes an image pickup element. The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. Alternatively, the image pickup unit 11402 may include a pair of image pickup elements for acquiring right-eye and left-eye image signals corresponding to three-dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy treatment device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

An example of the endoscopic surgery system to which the technology according to the present disclosure can be applied has been described above. The technology according to the present disclosure can be applied to the endoscope 11100, (the image pickup unit 11402 of) the camera head 11102, and the like out of the configurations described above. Specifically, the solid-state imaging device 111 of the present disclosure can be applied to the image pickup unit 10402. By applying the technology according to the present disclosure to the endoscope 11100, (the image pickup unit 11402 of) the camera head 11102, and the like, it is possible to improve yield and reduce cost related to manufacturing.

Here, the endoscopic surgery system has been described as an example, but the technology according to the present disclosure may be applied to other, for example, a microscopic surgery system or the like.

<14. Application Example to Mobile Body>

The technology according to the present disclosure (present technology) can be applied to various products. For example, the technology according to the present disclosure may be implemented as a device mounted on any type of mobile body such as an automobile, an electric vehicle, a hybrid electric vehicle, a motorcycle, a bicycle, a personal mobility, an airplane, a drone, a ship, a robot, and the like.

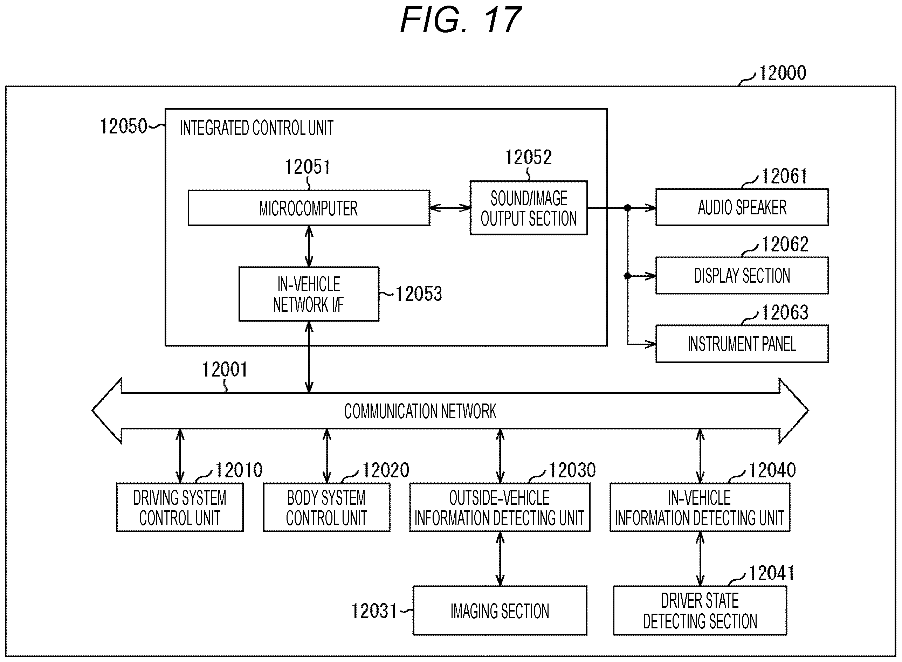

Fig. 17 is a block diagram depicting a schematic configuration example of a vehicle control system as an example of a mobile body control system to which the technology according to the present disclosure can be applied.

The vehicle control system 12000 includes a plurality of electronic control units connected to each other via a communication network 12001. In the example depicted in Fig. 17, the vehicle control system 12000 includes a driving system control unit 12010, a body system control unit 12020, an outside-vehicle information detecting unit 12030, an in-vehicle information detecting unit 12040, and an integrated control unit 12050. Further, a microcomputer 12051, a sound/image output section 12052, and an in-vehicle network interface (I/F) 12053 are depicted as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

Further, the microcomputer 12051 can output a control command to the body system control unit 12020 on the basis of the information about the outside of the vehicle, which is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example in Fig. 17, as the output device, an audio speaker 12061, a display section 12062, and an instrument panel 12063 are depicted. The display section 12062 may, for example, include at least one of an on-board display and a head-up display.

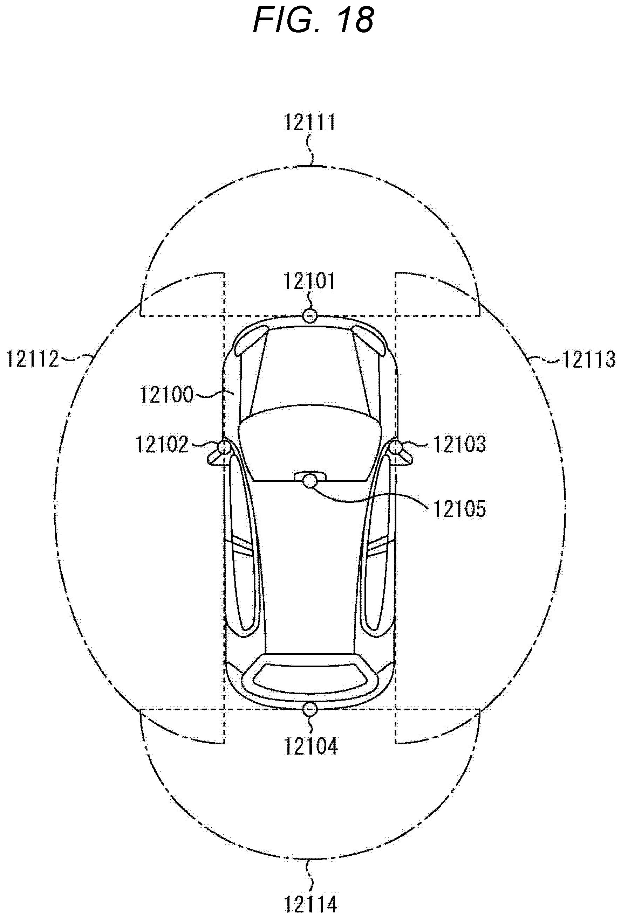

Fig. 18 is a diagram depicting an example of the installation position of the imaging section 12031.

In Fig. 18, a vehicle 12100 includes imaging sections 12101, 12102, 12103, 12104, and 12105, as the imaging section 12031.

The imaging sections 12101, 12102, 12103, 12104, and 12105 are, for example, provided at positions on a front nose, sideview mirrors, a rear bumper, a back door of the vehicle 12100, an upper portion of a windshield within the interior of the vehicle, and the like. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The images of the front obtained by the imaging sections 12101 and 12105 are used mainly to detect a preceding vehicle, a pedestrian, an obstacle, a signal, a traffic sign, a lane, or the like.

It is to be noted that, Fig. 18 depicts examples of imaging ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained with respect to a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure (present technology) can be applied has been described above. The technology according to the present disclosure can be applied to the imaging section 12031 and the like, for example, out of the configurations described above. Specifically, for example, the solid-state imaging device 111 of the present disclosure can be applied to the imaging section 12031. By applying the technology according to the present disclosure to the imaging section 12031, it is possible to improve yield and reduce cost related to manufacturing.

It is to be noted that the present technology is not limited to the above-described embodiments and application examples, and various modifications can be made without departing from the scope of the present technology.

Further, effects described in the present specification are merely examples and are not limited, and there may be other effects.

Further, the present technology can also have the following configurations.

[1] A solid-state imaging device including:

a first pixel provided on a semiconductor substrate;
a photoelectric conversion unit provided in the first pixel; and
a first recess of two or more steps formed on a light incident surface of the semiconductor substrate.

[2] The solid-state imaging device according to [1], in which a difference in height between the successive steps in the first recess satisfies the following Expression (1).

$$\mathrm{Log}\ (2)/\alpha < x < 0.6\ \mu m\ \cdots\ (1)$$

(In Expression (1), $\alpha$ is a light absorption coefficient of the semiconductor substrate, and x is a difference in height between successive steps.)

[3] The solid-state imaging device according to [1] or [2], in which an on-chip lens is provided on the light incident surface of the semiconductor substrate, and a width of a widest portion of an entrance on a light incident side of the first recess in a cross-sectional view satisfies the following Expression (2).

$$1.22\ *\ \lambda/n < y < W\ *\ (f-z)/f\ \cdots\ (2)$$

(In Expression (2), $\lambda$ is a wavelength of incident light, n is an n value of the on-chip lens, W is a size (width) of the on-chip lens, f is an F value of the on-chip lens, z is a distance from an uppermost portion on a light incident side of the on-chip lens to the widest portion of the entrance on the light incident side of the first recess, and y is a width of the widest portion of the entrance on the light incident side of the first recess.)

[4] The solid-state imaging device according to any one of [1] to [3], further including:

a second pixel adjacent to the first pixel; and
a second recess provided in the second pixel,
in which a width of the light incident surface of the semiconductor substrate between the first recess and the second recess satisfies the following Expression (3).

$$2 * Log (2)/\alpha < v < 1.2 \ \mu m \ \cdots \ (3)$$

(In Expression (3), $\alpha$ is a light absorption coefficient of the semiconductor substrate, and v is a width of the light incident surface of the semiconductor substrate between the first recess and the second recess.)

[5] The solid-state imaging device according to any one of [1] to [4], in which the first recess has a rectangular shape in a plan view of the first recess from a light incident side.

[6] The solid-state imaging device according to any one of [1] to [4], in which the first recess has a cross shape in a plan view of the first recess from a light incident side.

[7] The solid-state imaging device according to any one of [1] to [4], in which the first recess has a circular shape in a plan view of the first recess from a light incident side.

[8] The solid-state imaging device according to any one of [1] to [4], in which the first recess has a (x) shape in a plan view of the first recess from a light incident side.

[9] The solid-state imaging device according to any one of [1] to [8], in which each of the two or more steps is formed in a predetermined direction of the first recess in a plan view of the first recess from a light incident side.

[10] The solid-state imaging device according to any one of [1] to [9], in which the first pixel includes a plurality of the first recesses.

[11] The solid-state imaging device according to any one of [1] to [10], in which a position of a center of the first pixel and a position of a center of the first recess are different in a plan view from a light incident side.

[12] The solid-state imaging device according to any one of [1] to [11], in which an insulating layer and an on-chip lens are provided in this order on the light incident surface of the semiconductor substrate,
and a material constituting the insulating layer is different from a material constituting the on-chip lens.

[13] A solid-state imaging device including:

a semiconductor substrate;
a photoelectric conversion unit provided on the semiconductor substrate; and
a light-shielding wall provided above a light incident side of the semiconductor substrate,
in which the light-shielding wall includes a first portion having a first width extending in a direction substantially parallel to the light incident surface of the semiconductor substrate and a second portion having a second width extending in a direction substantially perpendicular to the light incident surface, the second width being smaller than the first width, and
the second portion is provided between the first portion and the semiconductor substrate.

[14] The solid-state imaging device according to [13], in which a plurality of pixels is arranged two-dimensionally,

at least one pixel of the plurality of pixels includes the two first portions,
an opening is formed by the two first portions,
each of the two first portions extending from each of the two pixel ends of the at least one pixel toward a central direction of the at least one pixel,
an on-chip lens is provided above the light-shielding wall, and
a width of the opening satisfies the following Expression (4) .

$$1.22 * \lambda/n < u < W * (f-z)/f \ \cdots \ (4)$$

(In Expression (4), $\lambda$ is a wavelength of incident light, n is an n value of the on-chip lens, W is a size (width) of the on-chip lens, f is an F value of the on-chip lens, z is a distance from an uppermost portion on a light incident side of the on-chip lens to the opening, and u is a width of the opening.)

[15] The solid-state imaging device according to [13] or [14], further including:

a first pixel provided on the semiconductor substrate;
a photoelectric conversion unit provided in the first pixel; and
a first recess of two or more steps formed on the light incident surface of the semiconductor substrate.

[16] The solid-state imaging device according to [15], in which a difference in height between the successive steps in the first recess satisfies the following Expression (1).

$$\text{Log } (2)/\alpha < x < 0.6 \; \mu m \; \cdots \; (1)$$

(In Expression (1), $\alpha$ is a light absorption coefficient of the semiconductor substrate, and $x$ is a difference in height between successive steps.)

[17] The solid-state imaging device according to [15] or [16], in which an on-chip lens is provided on the light incident surface of the semiconductor substrate, and

a width of a widest portion of an entrance on a light incident side of the first recess in a cross-sectional view satisfies the following Expression (2).

$$1.22 \; * \; \lambda/n < y < W \; * \; (f-z)/f \; \cdots \; (2)$$

(In Expression (2), $\lambda$ is a wavelength of incident light, $n$ is an n value of the on-chip lens, $W$ is a size (width) of the on-chip lens, $f$ is an F value of the on-chip lens, $z$ is a distance from an uppermost portion on a light incident side of the on-chip lens to the widest portion of the entrance on the light incident side of the first recess, and $y$ is a width of the widest portion of the entrance on the light incident side of the first recess.)

[18] The solid-state imaging device according to any one of [15] to [17], further including:

a second pixel adjacent to the first pixel; and
a second recess provided in the second pixel,
in which a width of the light incident surface of the semiconductor substrate between the first recess and the second recess satisfies the following Expression (3).

$$2 \; * \; \text{Log } (2)/\alpha < v < 1.2 \; \mu m \; \cdots \; (3)$$

(In Expression (3), $\alpha$ is a light absorption coefficient of the semiconductor substrate, and $v$ is a width of the light incident surface of the semiconductor substrate between the first recess and the second recess.)

[19] The solid-state imaging device according to any one of [15] to [18], in which the first recess has a rectangular shape in a plan view of the first recess from a light incident side.

[20] The solid-state imaging device according to any one of [15] to [18], in which the first recess has a cross shape in a plan view of the first recess from a light incident side.

[21] The solid-state imaging device according to any one of [15] to [18], in which the first recess has a circular shape in a plan view of the first recess from a light incident side.

[22] The solid-state imaging device according to any one of [15] to [18], in which the first recess has a (x) shape in a plan view of the first recess from a light incident side.

[23] The solid-state imaging device according to any one of [15] to [18], in which each of the two or more steps is formed in a predetermined direction of the first recess in a plan view of the first recess from a light incident side.

[24] The solid-state imaging device according to any one of [15] to [23], in which the first pixel includes a plurality of the first recesses.

[25] The solid-state imaging device according to any one of [15] to [24], in which a position of a center of the first pixel and a position of a center of the first recess are different in a plan view from a light incident side.

[26] The solid-state imaging device according to any one of [13] to [25], in which an insulating layer and an on-chip lens are provided in this order on the light incident surface of the semiconductor substrate,

and a material constituting the insulating layer is different from a material constituting the on-chip lens.

[27] An electronic device on which the solid-state imaging device according to any one of [1] to [26] is mounted.

REFERENCE SIGNS LIST

11(11-1, 11-2) Semiconductor substrate
50(50-1, 50-2), 51(51-1, 51-2), 52(52-1, 52-2), 53 On-chip lens (OCL)
71, 73(73A, 73B), 74(74A-1, 74A-2, 74B-1, 74B-2), 75(75A-1, 75A-2, 75B-1, 75B-2, 75C-1, 75C-2, 75D-1, 75D-2, 75E-1, 75E-2), 76(76A-1, 76A-2, 76B-1-1, 76B-1-2, 76B-2-1, 76B-2-2, 76C-1, 76C-2, 76D-1-1, 76D-1-2, 760D-1-1, 760D-1-2, 76D-2-1, 760D-2-1, 760D-2-2), 760(760D-1-1, 760D-1-2, 760D-2-1, 760D-2-2), 77(77A-1,77A-2, 77B-1-1, 77B-1-2, 77B-1-3, 77B-2-1, 77B-2-2, 77B-2-3, 77C-1, 77C-2), 79(79A-1, 79A-2), 790(790A-1, 790A-2), 80(80B), 800(800B), 81(81A, 81B, 81C, 81D), 810(810A, 810B, 810C, 810D) Recess

78(78A-1, 78A-2, 78B-1, 78B-2), 79(79B-1, 79B-2), 790(790B-1, 790B-2), 80(80C), 800(800C) Protrusion
101(101A, 101B, 101C, 101D), 103(103A, 103B), 104(104A, 104B), 105(105A-1, 105A-2, 105B-1, 105B-2, 105C-1, 105C-2, 105D-1, 105D-2, 105E-1, 105E-2), 106(106A-1, 106A-2, 106B-1, 106B-2, 106C-1, 106C-2, 106D-1, 106D-2), 107(107A-1, 107A-2, 107B-1, 107B-2, 107C-1, 107C-2), 108(108A-1, 108A-2, 108B-1, 108B-2), 109(109A-1, 109A-2, 109B-1, 109B-2), 110(110A, 110B,110C, 110D), 111(111A, 111B, 111C, 111D), 112(112A, 112B, 112C, )
Solid-state imaging device 301(301-1, 301-2), 302(302-1, 302-2) Light-shielding wall

**Claims**

1. A solid-state imaging device comprising:

   a first pixel provided on a semiconductor substrate;
   a photoelectric conversion unit provided in the first pixel; and
   a first recess of two or more steps formed on a light incident surface of the semiconductor substrate.

2. The solid-state imaging device according to claim 1,
   wherein a difference in height between the successive steps in the first recess satisfies a following Expression (1) .

$$\text{Log } (2)/\alpha < x < 0.6 \text{ µm} \quad \cdots \quad (1)$$

   (In Expression (1), $\alpha$ is a light absorption coefficient of the semiconductor substrate, and x is a difference in height between the successive steps.)

3. The solid-state imaging device according to claim 1,
   wherein an on-chip lens is provided on the light incident surface of the semiconductor substrate, and a width of a widest portion of an entrance on a light incident side of the first recess in a cross-sectional view satisfies a following Expression (2).

$$1.22 * \lambda/n < y < W * (f-z)/f \quad \cdots \quad (2)$$

   (In Expression (2), $\lambda$ is a wavelength of incident light, n is an n value of the on-chip lens, W is a size (width) of the on-chip lens, f is an F value of the on-chip lens, z is a distance from a top portion of the on-chip lens on a light incident side to the widest portion of the entrance on the light incident side of the first recess, and y is a width of the widest portion of the entrance on the light incident side of the first recess.)

4. The solid-state imaging device according to claim 1, further comprising:

   a second pixel adjacent to the first pixel; and
   a second recess provided in the second pixel,
   wherein a width of the light incident surface of the semiconductor substrate between the first recess and the second recess satisfies a following Expression (3).

$$2 * \text{Log } (2)/\alpha < v < 1.2 \text{ µm} \quad \cdots \quad (3)$$

   (In Expression (3), $\alpha$ is a light absorption coefficient of the semiconductor substrate, and v is a width of the light incident surface of the semiconductor substrate between the first recess and the second recess.)

5. The solid-state imaging device according to claim 1,
   wherein the first recess has a rectangular shape in a plan view of the first recess from a light incident side.

**6.** The solid-state imaging device according to claim 1,
wherein the first recess has a cross shape in a plan view of the first recess from a light incident side.

**7.** The solid-state imaging device according to claim 1,
wherein the first recess has a circular shape in a plan view of the first recess from a light incident side.

**8.** The solid-state imaging device according to claim 1,
wherein each of the two or more steps is formed in a predetermined direction of the first recess in a plan view of the first recess from a light incident side.

**9.** The solid-state imaging device according to claim 1,
wherein the first pixel includes a plurality of the first recesses.

**10.** The solid-state imaging device according to claim 1,
wherein a position of a center of the first pixel and a position of a center of the first recess are different in a plan view from a light incident side.

**11.** The solid-state imaging device according to claim 1,
wherein an insulating layer and an on-chip lens are provided in this order on the light incident surface of the semiconductor substrate,
and a material constituting the insulating layer is different from a material constituting the on-chip lens.

**12.** A solid-state imaging device comprising:

a semiconductor substrate;
a photoelectric conversion unit provided on the semiconductor substrate; and
a light-shielding wall provided above a light incident side of the semiconductor substrate,
wherein the light-shielding wall includes a first portion having a first width extending in a direction substantially parallel to a light incident surface of the semiconductor substrate and a second portion having a second width extending in a direction substantially perpendicular to the light incident surface, the second width being smaller than the first width, and
the second portion is provided between the first portion and the semiconductor substrate.

**13.** The solid-state imaging device according to claim 12,

wherein a plurality of pixels is arranged two-dimensionally,
at least one pixel of the plurality of pixels includes the two first portions,
an opening is formed by the two first portions,
each of the two first portions extending from each of the two pixel ends of the at least one pixel toward a central direction of the at least one pixel,
an on-chip lens is provided above the light-shielding wall, and
a width of the opening satisfies a following Expression (4).

$$1.22 * \lambda/n < u < W * (f-z)/f \cdots (4)$$

(In Expression (4), $\lambda$ is a wavelength of incident light, $n$ is an n value of the on-chip lens, W is a size (width) of the on-chip lens, f is an F value of the on-chip lens, z is a distance from an uppermost portion on a light incident side of the on-chip lens to the opening, and u is a width of the opening.)

**14.** The solid-state imaging device according to claim 12, further comprising:

a first pixel provided on the semiconductor substrate;
a photoelectric conversion unit provided in the first pixel; and
a first recess of two or more steps formed on the light incident surface of the semiconductor substrate.

**15.** The solid-state imaging device according to claim 14,

wherein a difference in height between the successive steps in the first recess satisfies a following Expression (1).

$$Log\ (2)/\alpha < x < 0.6\ \mu m\ \cdots\ (1)$$

(In Expression (1), $\alpha$ is a light absorption coefficient of the semiconductor substrate, and x is a difference in height between the successive steps.)

**16.** The solid-state imaging device according to claim 14,

wherein an on-chip lens is provided on the light incident surface of the semiconductor substrate, and a width of a widest portion of an entrance on a light incident side of the first recess in a cross-sectional view satisfies a following Expression (2).

$$1.22 * \lambda/n < y < W * (f-z)/f\ \cdots\ (2)$$

(In Expression (2), $\lambda$ is a wavelength of incident light, n is an n value of the on-chip lens, W is a size (width) of the on-chip lens, f is an F value of the on-chip lens, z is a distance from an uppermost portion on a light incident side of the on-chip lens to the widest portion of the entrance on the light incident side of the first recess, and y is a width of the widest portion of the entrance on the light incident side of the first recess.)

**17.** An electronic device on which the solid-state imaging device according to claim 1 is mounted.

# FIG. 1

| QE | 60.7% |
|---|---|
| REFLECTION LOSS | 37.0% |

A   B   C   D   E

EP 4 318 590 A1

## FIG. 2

Si REFLECTANCE

## FIG. 3

| COLOR | WAVELENGTH [μm] | DEPTH AT WHICH HALF IS ABSORBED [μm] |
|---|---|---|
| VIOLET | 400 | 0.093 |
| BLUE | 460 | 0.32 |
| GREEN | 530 | 0.79 |
| YELLOW | 580 | 1.2 |
| ORANGE | 610 | 1.5 |
| RED | 700 | 3.0 |

EP 4 318 590 A1

# FIG. 4

*FIG. 5*

EP 4 318 590 A1

FIG. 6

# FIG. 7

# FIG. 8

# FIG. 9

# FIG. 10

EP 4 318 590 A1

# FIG. 11

# FIG. 12

| QE | 35.4% |
|---|---|
| REFLECTION LOSS | 55.7% |

F

# FIG. 13

SECURITY

BEAUTY CARE

MEDICAL AND
HEALTHCARE

SPORTS

IMAGE SENSOR

HOUSEHOLD
ELECTRIC
APPLIANCES

AGRICULTURE

TRANSPORTATION

VIEWING

EP 4 318 590 A1

# FIG. 14

# FIG. 15

EP 4 318 590 A1

## FIG. 16

## FIG. 17

EP 4 318 590 A1

# FIG. 18

## INTERNATIONAL SEARCH REPORT

| International application No. |
| --- |
| **PCT/JP2022/003572** |

| A. | CLASSIFICATION OF SUBJECT MATTER |
| --- | --- |

*H01L 27/146*(2006.01)i; *H04N 5/369*(2011.01)i
FI: H01L27/146 A; H01L27/146 D; H04N5/369

According to International Patent Classification (IPC) or to both national classification and IPC

| B. | FIELDS SEARCHED |
| --- | --- |

Minimum documentation searched (classification system followed by classification symbols)

H01L27/146; H04N5/369

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | JP 2010-141280 A (SONY CORP.) 24 June 2010 (2010-06-24) | 1, 3, 5, 8, 10, 17 |
| | paragraphs [0032]-[0215], fig. 1, 4, 5, 21, 22 | |
| Y | | 9, 11, 14, 16 |
| A | | 2, 4, 6, 7, 12, 13, 15 |
| X | JP 2010-271049 A (SONY CORP.) 02 December 2010 (2010-12-02) | 1, 3, 5-8, 17 |
| | paragraphs [0018]-[0053], fig. 1, 2, 4 | |
| Y | | 9, 11, 14, 16 |
| A | | 2, 4, 10, 12, 13, 15 |
| Y | WO 2015/001987 A1 (SONY CORP.) 08 January 2015 (2015-01-08) | 9, 11 |
| | paragraphs [0026]-[0042], fig. 2 | |
| X | JP 2005-333131 A (SAMSUNG ELECTRONICS CO., LTD.) 02 December 2005 (2005-12-02) | 12, 13 |
| | paragraphs [0021]-[0030], fig. 2 | |
| Y | | 14, 16 |
| A | | 1-11, 15, 17 |

✓ Further documents are listed in the continuation of Box C.    ✓ See patent family annex.

| | | |
| --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" | document member of the same patent family |

| Date of the actual completion of the international search | Date of mailing of the international search report |
| --- | --- |
| **18 April 2022** | **26 April 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**EP 4 318 590 A1**

**INTERNATIONAL SEARCH REPORT**

| International application No. |
|---|
| **PCT/JP2022/003572** |

**C.    DOCUMENTS CONSIDERED TO BE RELEVANT**

| Category* | Citation of document, with indication, where appropriate, of the relevant passages | Relevant to claim No. |
|---|---|---|
| A | JP 2012-182432 A (CANON INC.) 20 September 2012 (2012-09-20) paragraphs [0009]-[0049], fig. 1 | 1-17 |

Form PCT/ISA/210 (second sheet) (January 2015)

51

**INTERNATIONAL SEARCH REPORT**
Information on patent family members

International application No.

**PCT/JP2022/003572**

| Patent document cited in search report | | | Publication date (day/month/year) | Patent family member(s) | | | Publication date (day/month/year) |
|---|---|---|---|---|---|---|---|
| JP | 2010-141280 | A | 24 June 2010 | US | 2010/0123811 | A1 | |
| | | | | paragraphs [0061]-[0242], fig. 1, 4, 5, 21, 22 | | | |
| | | | | KR | 10-2010-0055323 | A | |
| | | | | CN | 101740596 | A | |
| | | | | TW | 201027732 | A | |
| JP | 2010-271049 | A | 02 December 2010 | US | 2010/0295143 | A1 | |
| | | | | paragraphs [0043]-[0087], fig. 1, 2, 4 | | | |
| | | | | CN | 101894849 | A | |
| WO | 2015/001987 | A1 | 08 January 2015 | US | 2016/0112614 | A1 | |
| | | | | paragraphs [0052]-[0068], fig. 2 | | | |
| | | | | CN | 105229790 | A | |
| | | | | KR | 10-2016-0029735 | A | |
| JP | 2005-333131 | A | 02 December 2005 | US | 2005/0253212 | A1 | |
| | | | | paragraphs [0039]-[0049], fig. 7 | | | |
| | | | | EP | 1598873 | A1 | |
| | | | | KR | 10-2005-0109862 | A | |
| JP | 2012-182432 | A | 20 September 2012 | US | 2012/0200728 | A1 | |
| | | | | paragraphs [0031]-[0071], fig. 1 | | | |
| | | | | CN | 102637704 | A | |

Form PCT/ISA/210 (patent family annex) (January 2015)

**EP 4 318 590 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2015029054 A